# FASCICULE DE BREVET EUROPEEN

(11) **EP 3 524 044 B1**
(45) Date de publication et mention de la délivrance du brevet: **19.05.2021**
(21) Numéro de dépôt: 17793993.1
(22) Date de dépôt: 10.10.2017
(51) Int. Cl.: G06F 13/42, H04L 12/40, H05K 7/20

(54) **PROTOCOLE DE COMMUNICATION ENTRE PLUSIEURS MODULES DE REFROIDISSEMENT LIQUIDE DE SERVEURS INFORMATIQUES**
PROTOKOLL FÜR DIE KOMMUNIKATION ZWISCHEN EINER VIELZAHL VON MODULEN ZUR FLÜSSIGKEITSKÜHLUNG VON COMPUTERSERVERN
PROTOCOL FOR COMMUNICATION BETWEEN A PLURALITY OF MODULES FOR THE LIQUID COOLING OF COMPUTER SERVERS

(30) Priorité: 10.10.2016 FR 1659754
(43) Date de publication de la demande: 14.08.2019
(73) Titulaire: Bull SAS, 78340 Les Clayes-sous-Bois (FR)
(72) Inventeur: BONNIN, Jean-Christophe, 78120 Rambouillet (FR); ZEKRI, Elyès, 28630 Le Coudray (FR)
(74) Mandataire: Plasseraud IP
(86) Numéro de dépôt international: PCT/FR2017/052781
(87) Numéro de publication internationale: WO 2018/069634

(56) Documents cités:
- WO-A1-2016/019386
- WO-A1-2016/069417
- FR-A1- 2 924 554

## Description

### DOMAINE DE L'INVENTION

L'invention concerne le domaine des protocoles de communication entre plusieurs modules de refroidissement liquide d'un système de refroidissement d'un ou de plusieurs serveurs informatiques généralement regroupés à l'intérieur d'une même armoire informatique.

### CONTEXTE DE L'INVENTION

La publication WO2016/0193861 divulgue un système de refroidissement liquide comprenant deux modules de refroidissement liquide, le premier module en fonctionnement et le deuxième module au repos prêt à prendre la relève en cas de défaillance du premier module. Ce système de refroidissement, qui fonctionne en redondance 1+1, est relativement simple et robuste. En revanche, son efficacité est limitée. Avec des modules de refroidissement liquide de bonne taille, seulement 80 kW au total peuvent être dissipés au niveau d'une armoire informatique.

### RESUME DE L'INVENTION

Le but de la présente invention est de fournir une armoire informatique palliant au moins partiellement les inconvénients précités L'invention est définie dans la revendication 1, et les modes de réalisation dans les revendications dépendantes.

Plus particulièrement, l'invention vise à fournir une armoire informatique dont le système de refroidissement offre un meilleur compromis, entre la place requise dans l'armoire informatique et la robustesse en cas de panne de l'un des modules de refroidissement en fonctionnement de manière à moins perturber le fonctionnement de l'armoire informatique pour éviter de dégrader ses performances de calcul.

Selon l'invention, l'art antérieur précité soulève le dilemme suivant. Dans une première option, la redondance des modules est conservée, et le système de refroidissement est robuste en cas de panne ; par contre, il devient nécessaire de le sur-dimensionner notablement pour le refroidissement en régime normal, puisqu'un module de refroidissement de taille aussi importante que celui qui refroidit l'ensemble de l'armoire informatique reste au repos et donc inutilisé. Dans une deuxième option alternative, la redondance des modules n'est pas conservée, et le système de refroidissement peut être dimensionné au plus juste pour le refroidissement en régime normal ; en revanche, ce système de refroidissement est fragile en cas de panne même d'un seul module de refroidissement, car une panne entraîne alors automatiquement un chute très importante de la capacité de refroidissement laquelle est divisée par deux, nécessitant rapidement l'arrêt complet de l'armoire informatique associée.

Selon l'invention, il a été considéré d'améliorer l'art antérieur précité en passant à une redondance au moins 2+1, c'est-à-dire à au moins trois modules de refroidissement, au moins deux refroidissant en permanence, et le troisième au repos prêt à prendre la relève en cas de panne de l'un ou l'autre des deux modules de refroidissement en fonctionnement. Une architecture de maître/esclave a été envisagée. Si cette architecture reste robuste en cas de panne d'un module esclave, elle reste en revanche fragile en cas de panne du module maître, celui-ci constituant à nouveau un maillon faible du système de refroidissement. Par ailleurs, il faut disposer en stock de rechange, d'un certain nombre de modules de refroidissement maîtres en plus des modules de refroidissement esclaves.

L'invention propose alors de conserver plusieurs modules de refroidissement avantageusement interchangeables entre eux, tous refroidissant sauf l'un d'entre eux au repos de manière à pouvoir prendre la relève en cas de panne de l'un quelconque des modules de refroidissement en fonctionnement. Ces modules de refroidissement communiquent alors entre eux par un protocole collaboratif, sans maître/esclave, ce qui permet d'éviter le maillon faible, tout en permettant la palliation à la défaillance d'un module de refroidissement en fonctionnement ainsi que son remplacement sur site, sans arrêt ni du système de refroidissement ni de l'armoire informatique correspondante, tout en prenant globalement moins de place à l'intérieur de l'armoire informatique. Ce protocole collaboratif s'accompagne selon l'invention d'une plus grande autonomie de chaque module de refroidissement, car celui-ci va maintenant devoir réaliser certaines tâches qu'il ne réalisait pas auparavant. Lorsque les modules de refroidissement sont interchangeables entre eux, cela réduit également le nombre de types de modules de refroidissement de rechange à conserver.

Selon un mode de réalisation préférentiel de l'invention, il s'agit de refroidir au moins 120 kW en redondance 2 + 1. Trois modules d'une puissance de 60 kW chacun suffisent au lieu de deux modules d'une puissance de 120 kW chacun selon le troisième art antérieur. Le gain de place occupée dans l'armoire informatique est important. Il n'y a donc pas de contrôleur maître pour ne pas centraliser la gestion du refroidissement et en faire un point critique. La décentralisation retenue par l'invention a amené à utiliser un protocole de fonctionnement collaboratif, par conséquent sans maître esclave, où tous les modules de refroidissement communiquent au même niveau, sans relation hiérarchique entre eux, ils sont donc tous égaux entre eux.

Cette décentralisation va entraîner une plus grande robustesse du système de refroidissement en cas de panne. Cependant, à la différence d'une communication maître/esclave très directive, si plusieurs modules de refroidissement communiquent entre eux sur un pied d'égalité, par l'intermédiaire d'un protocole collaboratif, aucun n'étant le maître d'un autre module qui serait son esclave, un risque d'incohérence ou d'incompréhension dans cette communication non hiérarchisée entre modules de refroidissement peut surgir, pouvant amener des changements d'état prématurés pour l'un ou l'autre des modules de refroidissement, risquant alors, dans certaines conditions, d'amener une instabilité au niveau du système de refroidissement de l'armoire informatique dans son ensemble. Pour réduire ce risque d'instabilité, une étape de contrôle de cohérence de certaines données est explicitement prévue avant certains changements d'état, assortie également d'une vérification de la stabilité de cette cohérence dans le temps, lorsque cette cohérence a été constatée au moins ponctuellement.

Cette double précaution supplémentaire de vérification de cohérence et de stabilité de cette cohérence dans le temps, conserve toute sa souplesse au protocole collaboratif, l'essentiel de son efficacité, tout en réduisant voire en supprimant le risque de divergence ou d'instabilité du système global de refroidissement au niveau de l'armoire informatique qui proviendrait d'un changement d'état intempestif ou à tout le moins prématuré chez un ou plusieurs des modules de refroidissement de l'armoire informatique. Parmi les possibilités de changement d'état intempestif ou à tout le moins prématuré chez un ou plusieurs des modules de refroidissement de l'armoire informatique, c'est surtout le passage prématuré d'un module de refroidissement à l'état de module de refroidissement redondant, c'est-à-dire au repos, qui présente selon l'invention, le risque le plus critique d'instabilité de système de refroidissement. L'invention recherche en effet, pour la redondance, c'est-à-dire la mise au repos, d'un module de refroidissement, de pouvoir être stable dans le temps et de durer une période de temps assez longue sans interruption, afin de maintenir une meilleure efficacité de cette redondance. Si le module de refroidissement redondant, au repos donc, passe son temps à osciller entre repos et fonctionnement, il n'est pas tellement mieux que s'il restait en fonctionnement tout le temps.

A cette fin, la présente invention propose un procédé de communication entre plusieurs modules de refroidissement liquide d'un système de refroidissement d'un ou de plusieurs serveurs informatiques, caractérisé en ce que : les modules de refroidissement communiquent entre eux de manière à fonctionner en redondance N+1 avec N supérieur ou égal à 2, de façon à pouvoir effectuer un échange standard de l'un quelconque de ces modules de refroidissement sans arrêt du refroidissement et sans arrêt du fonctionnement du ou des serveurs, cette communication est assurée par un protocole collaboratif sans maître/esclave, avant de passer d'un mode actif où il refroidit à un mode de sauvegarde où il ne refroidit plus, le module de refroidissement redondant vérifie préalablement d'une part qu'un ensemble de données est cohérent entre tous ces modules de refroidissement et d'autre part que cette cohérence est maintenue pendant une durée prédéterminée.

Suivant des modes de réalisation préférés, l'invention comprend une ou plusieurs des caractéristiques suivantes qui peuvent être utilisées séparément ou en combinaison partielle entre elles ou en combinaison totale entre elles Cependant, les combinaisons non couvertes par les revendications ne font pas partie de l'invention.

De préférence, les modules de refroidissement communiquent entre eux sur un réseau Ethernet. Ce réseau Ethernet est très bien adapté à ces communications locales avec échange de messages simples entre modules de refroidissement au sein d'une armoire.

De préférence, ce réseau Ethernet est aussi le réseau sur lequel transitent des commandes externes à destination des serveurs informatiques et qui est le réseau général de cluster informatique regroupant plusieurs armoires informatiques pouvant participer à l'exécution d'une même tâche informatique. Ainsi, le réseau Ethernet existant est rentabilisé et il n'est pas nécessaire d'augmenter la complexité du système de refroidissement en ajoutant un réseau supplémentaire dédié.

De préférence, lors d'une phase d'initialisation, chaque module de refroidissement diffuse au moins son identifiant et un identifiant de l'armoire informatique dans laquelle il est situé. Ainsi, les différents modules de refroidissement d'un même groupe localisé dans une même armoire informatique peuvent être sûrs de toucher rapidement les autres modules de refroidissement de ce groupe, alors qu'ils ne les connaissent pas encore.

De préférence, lors de cette phase d'initialisation, chaque module de refroidissement ayant reçu l'identifiant d'un autre module de refroidissement situé dans la même l'armoire informatique que lui, lui renvoie un message ciblé accusant réception et communiquant son propre identifiant et un identifiant de leur armoire informatique commune, de façon à former un groupe d'échange d'informations isolé des autres modules de refroidissement appartenant à d'autres groupes d'échange d'informations. Ainsi, les différents modules de refroidissement d'un même groupe localisé dans une même armoire informatique peuvent mettre en place la communication intra-groupe avec tous les modules de refroidissement concernés sans être parasités par les modules de refroidissement d'autres groupes.

De préférence, après l'achèvement de cette phase d'initialisation, chaque module de refroidissement envoie périodiquement, avec une période de rafraîchissement, ses données aux autres modules de refroidissement du groupe d'échange d'informations qu'il a identifiés. Ainsi, tous les modules de refroidissement d'une même armoire informatique ont une connaissance à jour, éventuellement presqu'en temps réel, des données des autres modules de refroidissement de l'armoire informatique, ce qui améliore et fluidifie le fonctionnement de la communication entre modules, surtout que cette communication est basée sur un protocole collaboratif pour lequel il est d'autant plus intéressant que les modules de refroidissement aient le plus souvent possible des données à jour.

De préférence, chacun des modules de refroidissement peut avoir au moins les deux statuts suivants : dans le mode actif, un statut autonome, dans lequel le module de refroidissement refroidit correctement, mais ne parvient pas à se synchroniser avec tous les autres modules de refroidissement, et toujours dans le mode actif, un statut régulé, dans lequel le module de refroidissement refroidit correctement, et parvient à se synchroniser avec tous les autres modules de refroidissement. Ainsi, l'existence de ces deux modes de fonctionnement améliore le fonctionnement global du système de refroidissement, d'une part en autorisant un refroidissement efficace même si non optimisé en l'absence de synchronisation entre les modules de refroidissement permettant alors tout de même le fonctionnement des serveurs informatiques de l'armoire informatique, et d'autre part en offrant un refroidissement optimisé en présence de synchronisation entre les modules de refroidissement qui lui va permettre le passage d'un module de refroidissement en redondance, c'est-à-dire au repos, dans des conditions optimales.

De préférence, chacun des modules de refroidissement peut avoir au moins les deux statuts suivants : en cas de panne, un statut défaillant, dans lequel le module de refroidissement a arrêté de refroidir correctement alors qu'il devrait continuer à refroidir correctement, dans le mode de sauvegarde, un statut redondant, dans lequel le module de refroidissement est au repos mais reste prêt à remplacer immédiatement un autre module de refroidissement qui deviendrait défaillant. Le statut défaillant de l'un des modules de refroidissement va alerter l'autre module de refroidissement au statut redondant, lui permettant de le remplacer dans l'opération de refroidissement suffisant des serveurs informatiques de l'armoire informatique.

De préférence, lorsqu'un module de refroidissement passe dans le statut défaillant, il arrête lui-même sa pompe de circulation de fluide caloporteur dans le circuit hydraulique secondaire. En l'absence de module de refroidissement maître, chaque module de refroidissement a des tâches supplémentaires à effectuer de lui-même pour assurer une meilleure marche du système de refroidissement global.

De préférence, lorsqu'au départ, l'un des modules de refroidissement réussit à passer dans le statut autonome, l'armoire informatique est démarrée et les serveurs informatiques qu'elle contient également. Ainsi, d'une part le fonctionnement de l'armoire informatique démarre très rapidement, tout en vérifiant d'autre part qu'un refroidissement minimal est déjà disponible, afin d'éviter de devoir arrêter en catastrophe une armoire informatique commençant à fonctionner mais sans refroidissement suffisant.

De préférence, les modules de refroidissement possèdent chacun un jeu de paramètres comprenant : un paramètre de module de refroidissement redondant pointant sur l'identifiant du module de refroidissement habilité à passer au statut redondant à la prochaine occasion favorable, au moins un paramètre de régulation du refroidissement pointant sur une valeur de consigne d'un paramètre régulant le refroidissement. Ainsi, disposant au moins de ces quelques paramètres intéressants, les modules de refroidissement ont chacun un état des lieux plus complet du système de refroidissement.

De préférence, le paramètre de régulation du refroidissement est la température cible du fluide caloporteur dans le circuit hydraulique secondaire en sortie de l'échangeur de chaleur. En effet, ce paramètre est spécialement représentatif du bon fonctionnement du système de refroidissement, garantissant mieux le fait que la température des serveurs informatiques ne s'approche pas de la limite admissible.

De préférence, chaque module de refroidissement a un indicateur de cohérence qui est positif lorsque sont remplies simultanément les trois conditions suivantes : ledit module de refroidissement a reçu de la part de tous les autres modules de refroidissement les valeurs, d'au moins le paramètre de module de refroidissement redondant et le paramètre de régulation du refroidissement, mises à jour depuis moins d'une première durée prédéterminée, toutes les valeurs du paramètre de module de refroidissement redondant reçues sont égales à sa propre valeur du paramètre de module de refroidissement redondant, pendant plus d'une deuxième durée prédéterminée, toutes les valeurs du paramètre de régulation de refroidissement reçues sont égales à sa propre valeur du paramètre de régulation de refroidissement, pendant plus d'une troisième durée prédéterminée, qui est négatif si au moins l'une de ces trois conditions n'est pas remplie, ledit module de refroidissement ne passant du statut autonome au statut régulé que lorsque son indicateur de cohérence devient positif. C'est cet indicateur de cohérence qui permet à tous les modules de refroidissement de vérifier à la fois efficacement et simplement que leur synchronisation entre eux est réalisée, et que bientôt des conditions favorables pour une optimisation du passage en redondance de l'un d'entre eux devraient se réaliser.

De préférence, la première durée vaut au moins le double de la période de rafraîchissement des données par les modules de refroidissement, la première durée valant de préférence entre 1 et 10 secondes, encore plus de préférence entre 2 et 10 secondes. Ces durées améliorent la réactivité du système de refroidissement en cas de dérive, sans augmenter notablement le risque d'instabilité de l'asservissement du refroidissement.

De préférence, les deuxième et troisième durées valent entre 5 et 60 secondes, encore plus de préférence entre 10 et 60 secondes, les deuxième et troisième durée étant avantageusement égales entre elles. Ces durées améliorent la réactivité du système de refroidissement en cas de dérive, sans augmenter notablement le risque d'instabilité de l'asservissement du refroidissement.

De préférence, lorsqu'un module de refroidissement ne communique plus ses données aux autres modules de refroidissement, ses données stockées en mémoire ne sont plus prises en compte dans l'évaluation des indicateurs de cohérence des autres modules de refroidissement. Ainsi, la communication entre modules de refroidissement et leur prise de décision associée aux données communiquées n'est plus polluée par des données obsolètes ne correspondant plus à l'état effectif du module de refroidissement qu'elles étaient censées représenter.

De préférence, chaque module de refroidissement a un indicateur de stabilité qui est positif lorsque sont remplies simultanément les trois conditions suivantes : les indicateurs de cohérence de tous les modules de refroidissement sont positifs depuis au moins une quatrième durée, de préférence supérieure aux première, deuxième et troisième durées, aucun module de refroidissement n'a reçu d'alarme de dysfonctionnement du refroidissement, au plus un seul des modules de refroidissement est dans le statut redondant, tous les modules ou tous les autres modules de refroidissement sont dans le statut régulé, qui est négatif si au moins l'une de ces trois conditions n'est pas remplie, ledit module de refroidissement ne passant du statut régulé au statut redondant que lorsque sont remplies simultanément les deux conditions suivantes : son paramètre de module de refroidissement redondant pointe sur son propre identifiant de module de refroidissement, son indicateur de stabilité devient positif. C'est cet indicateur de stabilité qui permet à tous les modules de refroidissement de vérifier à la fois efficacement et simplement non seulement que leur synchronisation entre eux est réalisée mais aussi que cette synchronisation reste stable dans le temps, et que les conditions favorables attendues pour une optimisation du passage en redondance de l'un d'entre eux sont réalisées.

De préférence, la quatrième durée est supérieure à 1 minute, est de préférence comprise entre 2 et 5 minutes. Ces durées améliorent la réactivité du système de refroidissement en cas de dérive, sans augmenter notablement le risque d'instabilité de l'asservissement du refroidissement.

De préférence, si tous les modules de refroidissement restent dans le statut autonome pendant au moins une cinquième durée prédéterminée, alors il y a une intervention d'un opérateur extérieur à l'armoire informatique, cette cinquième durée étant de préférence supérieure à 10 minutes. En effet, si les modules de refroidissement ont tous atteint le statut autonome, c'est qu'ils peuvent fonctionner, tandis que s'ils ne parviennent pas à se synchroniser dans un temps raisonnable, c'est probablement qu'il existe un problème d'un autre niveau, par conséquent difficile à résoudre par les seuls modules de refroidissement et l'intervention de l'opérateur, qu'on essaye de minimiser en raison de son coût, devient alors très utile et donc rentable.

De préférence, lorsqu'un module de refroidissement est passé dans le statut défaillant, ses données ne sont plus prises en compte dans l'évaluation des indicateurs de cohérence des autres modules de refroidissement. Ainsi, la communication entre modules de refroidissement et leur prise de décision associée aux données communiquées n'est plus polluée par des données obsolètes ne correspondant plus à l'état effectif du module de refroidissement qu'elles étaient censées représenter.

De préférence, les données envoyées par chaque module de refroidissement, aux autres modules de refroidissement, comprennent : un identifiant de son groupe de modules de refroidissement destinés à communiquer ensemble et situés dans une même armoire informatique, refroidissant ensemble un groupe de serveurs informatiques situés dans cette armoire informatique, son propre identifiant de module de refroidissement, la valeur de son paramètre de module de refroidissement redondant, la valeur de son paramètre de régulation du refroidissement, un paramètre binaire correspondant à la présence ou à l'absence d'une alarme de dysfonctionnement du refroidissement. Ainsi, disposant au moins de ces quelques paramètres intéressants et échangeant entre eux leurs valeurs, les modules de refroidissement ont chacun un état des lieux encore plus complet du système de refroidissement.

De préférence, la période de rafraîchissement est comprise entre 0.5 et 2 secondes. Cette durée améliore la réactivité du système de refroidissement en cas de dérive, sans augmenter notablement le risque d'instabilité de l'asservissement du refroidissement.

De préférence, lorsque l'un des modules de refroidissement passe dans le statut défaillant, alors : son paramètre de module de refroidissement redondant pointe sur son propre identifiant de module de refroidissement, un ordre est envoyé aux autre modules de refroidissement de pointer leur paramètre de module de refroidissement redondant sur l'identifiant de ce module de refroidissement devenu défaillant, le module de refroidissement qui est dans le statut redondant, passe dans le statut régulé ou dans le statut autonome, l'alimentation électrique de tous les éléments fonctionnels de ce module de refroidissement devenu défaillant, à l'exception de sa carte électronique de contrôle, est désactivée. Ainsi, le passage de témoin entre module de refroidissement défaillant et module de refroidissement redondant devant le remplacer, est rendu plus fluide.

De préférence, lorsque l'un des modules de refroidissement est passé dans le statut défaillant, il peut ensuite passer dans le statut exclu, et alors : une commande spécifique de l'opérateur décide l'exclusion de ce module de refroidissement, une commande spécifique de l'opérateur décidant l'inclusion de ce module de refroidissement sera nécessaire pour remettre en marche le module de refroidissement exclu, un simple redémarrage de sa carte électronique de contrôle ne permettant pas ladite remise en marche.

De préférence, lorsque l'un des modules de refroidissement sort du statut exclu, alors : une commande spécifique de l'opérateur décide l'inclusion de ce module de refroidissement, l'alimentation électrique de tous les éléments fonctionnels de ce module de refroidissement devenu défaillant est réactivée.

Ainsi, la décision d'exclusion ayant été prise explicitement, pour inclure de nouveau le module de refroidissement correspondant dans le système de refroidissement en fonctionnement, il est plus prudent et plus sécurisé, de requérir une décision explicite également, ceci afin de réduire le risque d'instabilité du système de refroidissement global.

De préférence, lorsque l'un des modules de refroidissement est passé dans le statut autonome ou dans le statut régulé ou dans le statut redondant, il peut ensuite passer directement dans le statut exclu sans passer par le statut défaillant, et alors : une commande spécifique de l'opérateur décide l'exclusion de ce module de refroidissement, une commande spécifique de l'opérateur décidant l'inclusion de ce module de refroidissement sera nécessaire pour remettre en marche le module de refroidissement exclu, un simple redémarrage de sa carte électronique de contrôle ne permettant pas ladite remise en marche. Outre la défaillance, d'autres types de dysfonctionnement entraînant un risque pour le système global de refroidissement, sont susceptibles d'entraîner l'exclusion du module de refroidissement sujet à ces autres types de dysfonctionnement.

D'autres caractéristiques et avantages de l'invention apparaîtront à la lecture de la description qui suit d'un mode de réalisation préféré de l'invention, donnée à titre d'exemple et en référence aux dessins annexés.

Un autre objet de l'invention vise à fournir une armoire informatique dont le système de refroidissement offre un meilleur compromis, entre la place requise dans l'armoire informatique et la robustesse en cas de panne de l'un des modules de refroidissement en fonctionnement, de manière à moins perturber le fonctionnement de l'armoire informatique pour éviter de dégrader ses performances de calcul.

Selon cet autre objet de l'invention, le refroidissement par air n'est pas retenu, car il est intrinsèquement limité par la capacité calorifique de l'air nettement plus faible que celle d'un liquide caloporteur. Or, avec un cluster informatique regroupant un grand nombre d'armoires informatiques avec une grande densité, chaque armoire informatique regroupant un nombre notable de serveurs informatiques empilés les uns sur les autres avec une densité importante, les besoins en performance de refroidissement semblent trop élevés pour être satisfaites par un refroidissement par air.

Selon cet autre objet de l'invention, le refroidissement par eau avec composants déportés hors de l'armoire n'est pas retenu, car il nécessite des éléments mutualisés de grande taille, comme les pompes de circulation de fluide caloporteur, ce qui peut présenter deux inconvénients. Le premier inconvénient réside dans le fait que ces éléments de grande taille prennent une place importante, ce qui peut devenir critique avec un cluster informatique regroupant un grand nombre d'armoires informatiques avec une grande densité, chaque armoire informatique regroupant un nombre notable de serveurs informatiques empilés les uns sur les autres avec une densité importante. Le deuxième inconvénient réside dans le fait que ces éléments mutualisés, peuvent se révéler des maillons faibles de l'ensemble du système, du fait même de leur mutualisation, en cas de panne. En effet, non seulement ces éléments doivent être arrêtés, mais aussi toutes les armoires informatiques qui dépendent, pour leur refroidissement, de ces éléments en panne, ainsi que bien sûr tous leurs serveurs informatiques, ce qui peut entraîner une sérieuse baisse de performance de calcul pour le cluster informatique, en cas de panne de certains éléments de son système de refroidissement informatique.

Selon cet autre objet de l'invention, un refroidissement par eau avec deux modules de refroidissement en redondance 1+1 soulève le dilemme suivant. Dans une première option, la redondance des modules est conservée, et le système de refroidissement est robuste en cas de panne ; par contre, il devient nécessaire de le sur-dimensionner notablement pour le refroidissement en régime normal, puisqu'un module de refroidissement de taille aussi importante que celui qui refroidit l'ensemble de l'armoire informatique reste au repos et donc inutilisé. Dans une deuxième option alternative, la redondance des modules n'est pas conservée, et le système de refroidissement peut être dimensionné au plus juste pour le refroidissement en régime normal ; en revanche, ce système de refroidissement est fragile en cas de panne même d'un seul module de refroidissement, car une panne entraîne alors automatiquement un chute très importante de la capacité de refroidissement laquelle est divisée par deux, nécessitant rapidement l'arrêt complet de l'armoire informatique associée.

Selon cet autre objet de l'invention, il a été considéré d'améliorer cette redondance 1+1 en passant à une redondance au moins 2+1, c'est-à-dire au moins trois modules de refroidissement, dont au moins deux refroidissant en permanence, et le troisième au repos reste prêt à prendre la relève en cas de panne de l'un ou l'autre des deux modules de refroidissement en fonctionnement. Une architecture de maître/esclave a été envisagée. Si cette architecture reste robuste en cas de panne d'un module esclave, elle devient en revanche fragile en cas de panne du module maître, celui-ci constituant à nouveau un maillon faible du système de refroidissement. Par ailleurs, il faut disposer en stock de rechange, d'un certain nombre de modules de refroidissement maîtres en plus des modules de refroidissement esclaves.

Cet autre objet de l'invention propose alors de conserver plusieurs modules de refroidissement avantageusement interchangeables entre eux, tous refroidissant sauf l'un d'entre eux au repos de manière à pouvoir prendre la relève en cas de panne de l'un quelconque des modules de refroidissement en fonctionnement. Ces modules de refroidissement communiquent alors entre eux par un protocole collaboratif, sans maître/esclave, ce qui permet d'éviter le maillon faible, tout en palliant à la défaillance d'un module de refroidissement en fonctionnement tout en assurant son remplacement sur site, sans arrêt ni du système de refroidissement ni de l'armoire informatique correspondante, tout en prenant globalement moins de place à l'intérieur de l'armoire informatique. Ce protocole collaboratif s'accompagne selon cet autre objet de l'invention d'une plus grande autonomie de chaque module de refroidissement, car celui-ci va maintenant devoir réaliser certaines tâches qu'il ne réalisait pas auparavant. Lorsque les modules de refroidissement sont interchangeables entre eux, cela réduit également le nombre de types de modules de refroidissement de rechange à conserver.

Selon un mode de réalisation préférentiel de cet autre objet de l'invention, il s'agit de refroidir, au niveau des serveurs informatiques d'une même armoire informatique, au moins 120 kW en redondance 2 + 1. Trois modules d'une puissance de 60 kW chacun suffisent au lieu de deux modules d'une puissance de 120 kW chacun selon la redondance 1+1. Le gain de place occupée dans l'armoire informatique est important. Il n'y a donc pas de contrôleur maître pour ne pas centraliser la gestion du refroidissement et éviter d'en faire un point critique. La décentralisation retenue par cet autre objet de l'invention a amené à utiliser un protocole de fonctionnement collaboratif, donc sans maître esclave, où tous les modules de refroidissement communiquent au même niveau, sans relation hiérarchique entre eux, ils sont donc tous égaux entre eux.

A cette fin, cet autre objet de l'invention propose une armoire informatique, comprenant : au moins un serveur informatique, au moins un module de refroidissement liquide de ce serveur, caractérisée en ce que : l'armoire comprend au moins 3 modules de refroidissement liquide communiquant entre eux par un protocole collaboratif sans maître/esclave, de manière à fonctionner en redondance N+l avec N supérieur ou égal à 2, de façon à pouvoir effectuer un échange standard de l'un quelconque de ces modules de refroidissement sans arrêt du refroidissement de l'armoire informatique et sans arrêt du fonctionnement du serveur situé dans l'armoire informatique, chacun de ces modules de refroidissement liquide comprenant son propre système de régulation du refroidissement et de détection de panne.

A cette fin, cet autre objet de l'invention propose également un système de refroidissement comprenant au moins un module de refroidissement liquide d'au moins un serveur informatique situé dans une armoire informatique, caractérisé en ce que : l'armoire comprend au moins 3 modules de refroidissement liquide qui sont situés dans l'armoire informatique et qui communiquent entre eux par un protocole collaboratif sans maître/esclave, de manière à fonctionner en redondance N+l avec N supérieur ou égal à 2, de façon à pouvoir effectuer un échange standard de l'un quelconque de ces modules de refroidissement sans arrêt du refroidissement de l'armoire informatique et sans arrêt du fonctionnement du serveur situé dans l'armoire informatique, chacun de ces modules de refroidissement liquide comprenant son propre système de régulation du refroidissement et de détection de panne.

Ainsi, selon des modes de réalisation préférentiels de cet autre objet de l'invention, le module de refroidissement liquide est interchangeable pour la maintenance sans arrêt de fonctionnement de l'armoire informatique ni des serveurs informatiques qu'elle contient. Ce module de refroidissement liquide dispose alors de sa propre électronique de régulation et de détection de pannes, avec fonctionnement autonome et collaboratif entre les modules de refroidissement liquide d'une même armoire informatique, sans contrôleur maître au niveau de l'armoire informatique. La redondance optimisée réduit la consommation d'énergie avec n modules en fonctionnement et un seul au repos. La décision de mise au repos pour le module en redondance est prise, sur la base d'un algorithme collaboratif, par l'ensemble des modules de refroidissement d'une même armoire informatique.

Suivant des modes de réalisation préférés, cet autre objet de l'invention comprend une ou plusieurs des caractéristiques suivantes qui peuvent être utilisées séparément ou en combinaison partielle entre elles ou en combinaison totale entre elles, avec l'un ou l'autre de tous les autres objets de l'invention.

De préférence, l'armoire informatique comprend un circuit hydraulique secondaire refroidissant directement les serveurs informatiques, et les modules de refroidissement liquide sont branchés sur ce circuit hydraulique secondaire en parallèle les uns des autres. Ainsi, l'indépendance des différents modules de refroidissement entre eux en cas de panne est mieux assurée et ceci, sans nécessiter de circuits de dérivation qui ajouteraient à la complexité du système de refroidissement.

De préférence, l'armoire informatique comprend une portion de circuit hydraulique primaire destinée à être reliée à une source froide extérieure à l'armoire informatique, et les modules de refroidissement liquide sont branchés sur cette portion de circuit hydraulique primaire en parallèle les uns des autres. Ainsi, l'indépendance des différents modules de refroidissement entre eux en cas de panne est mieux assurée et ceci, sans nécessiter de circuits de dérivation qui ajouteraient à la complexité du système de refroidissement.

De préférence, l'armoire informatique comprend un circuit hydraulique secondaire refroidissant directement les serveurs informatiques, et la température du liquide caloporteur dans ce circuit hydraulique secondaire est comprise entre 20°C et 45°C. Cette plage de températures assure un bon fonctionnement de la majorité des serveurs informatiques à refroidir.

De préférence, l'un des modules de refroidissement reste à l'arrêt pendant la majorité du temps de refroidissement, de préférence pendant au moins 90% du temps de refroidissement. Ainsi, la redondance joue à plein, et en cas de panne d'un autre des modules de refroidissement, celui-ci sera prêt à prendre la relève avec nettement moins de risque de tomber lui aussi en panne dans la foulée.

Selon une première alternative, c'est toujours le même module de refroidissement qui reste à l'arrêt pendant la majorité du temps de refroidissement. En cas de panne d'un autre des modules de refroidissement, celui-ci sera comme neuf et prêt à prendre la relève sans risque de tomber lui aussi en panne dans la foulée.

Selon une deuxième alternative, c'est, à tour de rôle et de manière périodique, successivement chacun des modules de refroidissement qui reste à l'arrêt pendant la majorité du temps de refroidissement. En cas de panne d'un autre des modules de refroidissement, celui-ci sera prêt à prendre la relève avec un risque relativement faible de tomber lui aussi en panne dans la foulée. Tous les modules de refroidissement d'une même armoire informatique vont être utilisés régulièrement et vont présenter un degré similaire d'usure, ce qui peut simplifier la gestion du parc de modules de refroidissement dans une même salle informatique.

De préférence, tous les modules de refroidissement refroidissent ensemble pendant une minorité du temps de refroidissement, de préférence seulement pendant une phase d'initialisation et/ou pendant une phase de réinitialisation des modules de refroidissement et/ou pendant un dysfonctionnement passager d'une source froide extérieure à laquelle est reliée l'armoire informatique par l'intermédiaire d'une portion de circuit hydraulique primaire. Ainsi, non seulement le module de refroidissement redondant, c'est-à-dire au repos, peut prendre la relève en cas de panne de l'un des autres modules de refroidissement, mais en cas de conditions défavorables lorsque les autres modules de refroidissement, sans être eux-mêmes défaillants, ne parviennent plus à assurer le niveau de refroidissement voulu, le module de refroidissement redondant peut prêter main forte aux autres modules de refroidissement lesquels continuent alors tous de fonctionner.

De préférence, l'armoire comprend au moins entre 3 et 5 modules de refroidissement liquide communiquant entre eux par un protocole collaboratif sans maître/esclave, de manière à fonctionner en redondance N+1 avec N compris entre 2 et 4, de façon à pouvoir effectuer un échange standard de l'un quelconque de ces modules de refroidissement sans arrêt du refroidissement de l'armoire informatique et sans arrêt du fonctionnement du serveur situé dans l'armoire informatique. Ce nombre modéré mais suffisant de modules de refroidissement constitue un très bon compromis entre d'une part l'efficacité en régime normal de refroidissement et d'autre part la robustesse en cas de panne.

De préférence, les modules de refroidissement liquide communiquent entre eux sur un pied d'égalité, n'étant soumis qu'à un gestionnaire général lequel, d'une part gère un parc d'armoires informatiques refroidissant un cluster de serveurs informatiques et d'autre part gère pour ce cluster de serveurs informatiques, en plus de son refroidissement par le parc d'armoires informatiques, plusieurs autres fonctions parmi lesquelles le démarrage du cluster de serveurs informatiques et leur affectation de tâches, par exemple de tâches de calcul. Cela rend le système de refroidissement plus robuste dans son ensemble en cas de panne, car évitant les maillons faibles, même à un niveau supérieur dans l'architecture du cluster, tout en améliorant l'autonomie de chacun des modules de refroidissement.

De préférence, chaque module de refroidissement dissipe une puissance calorique d'au moins 50kW, de préférence d'au moins 60kW. Ainsi, une simple redondance 2+1 assure déjà la dissipation efficace d'une grosse quantité de chaleur tout en évitant de prendre trop de place dans l'armoire informatique.

De préférence, l'armoire informatique comprend un circuit hydraulique secondaire refroidissant directement les serveurs informatiques, l'armoire informatique comprend une portion de circuit hydraulique primaire destinée à être reliée à une source froide extérieure à l'armoire informatique, un échangeur de chaleur refroidissant le circuit hydraulique secondaire par le circuit hydraulique primaire, et le différentiel de température entre la sortie du circuit hydraulique secondaire et l'entrée du circuit hydraulique primaire est compris entre 0°C et 6°C. Ainsi, l'échangeur de chaleur présente un bon compromis entre efficacité de refroidissement et compacité dans le module de refroidissement.

De préférence, le système de régulation du refroidissement et de détection de panne de chaque module de refroidissement comprend un ou plusieurs capteurs de température, un ou plusieurs capteurs de pression, un capteur de fuite d'eau, un capteur de position angulaire d'ouverture de vanne. L'ensemble de ces capteurs assure un bon fonctionnement du module de refroidissement en régime normal de refroidissement, tout en assurant une réactivité importante en cas de panne ou de dysfonctionnement.

De préférence, le système de régulation du refroidissement et de détection de panne de chaque module de refroidissement comprend un actionneur du relais électrique chargé de mettre une pompe du module de refroidissement en marche et de l'arrêter, et un actionneur de la vanne chargé de contrôler l'angle d'ouverture de cette vanne. Ces différents éléments contribuent à améliorer l'autonomie du module de refroidissement.

De préférence, tous les modules de refroidissement sont interchangeables entre eux, de préférence identiques entre eux. Cela réduit le nombre de types de modules de refroidissement de rechange à conserver.

De préférence, tous les modules de refroidissement liquide sont situés dans la partie inférieure de l'armoire informatique, en dessous de tous les serveurs informatiques. Ainsi, en cas de fuite limitée de fluide caloporteur dans un module de refroidissement, le liquide en fuite ne risque ni de ruisseler sur l'un des serveurs informatiques ni d'en perturber le fonctionnement.

De préférence, le fluide caloporteur circulant dans le circuit hydraulique secondaire présente une pression résiduelle, lorsqu'il n'est plus pompé, qui est supérieure à 0.8 bars, de préférence supérieure à 1.2 bars, encore plus de préférence supérieure à 2 bars. Ainsi, le risque de cavitation de la pompe est réduit, voire supprimé.

De préférence, l'armoire informatique comprend une portion de circuit hydraulique primaire et un circuit hydraulique secondaire situés de part et d'autre d'un échangeur de chaleur, une vanne régulant le débit dans la portion de circuit hydraulique primaire, un capteur de température dans le circuit hydraulique secondaire situé en sortie de l'échangeur, ladite vanne étant asservie sur ledit capteur de température, de préférence par un asservissement de type proportionnel / intégrateur / dérivateur (PID). Ce type d'asservissement, simple et efficace, convient et suffit pour réguler correctement le refroidissement d'une armoire informatique.

De préférence, chaque module de refroidissement liquide comprend son propre échangeur de chaleur entre une portion de circuit hydraulique primaire et un circuit hydraulique secondaire, et sa propre pompe pour faire circuler un fluide caloporteur dans le circuit hydraulique secondaire. Ainsi, l'autonomie du module de refroidissement est améliorée.

De préférence, la seule opération de maintenance du système de refroidissement qui est autorisée sur le site de l'armoire informatique, est l'échange standard de module de refroidissement qui consiste d'une part en la dépose du module de refroidissement défaillant et d'autre part en son remplacement par un module de refroidissement de réserve sans interruption ni du refroidissement ni du fonctionnement du ou des serveurs informatiques. Cette maintenance facilitée et sécurisée est rendue possible par la structure de l'armoire informatique et de son système de refroidissement, à base de modules de refroidissement autonomes et avantageusement interchangeables, proposée par cet autre objet de l'invention

Encore un autre objet de l'invention vise à fournir un module de refroidissement liquide autonome, intégrant ses propres composants clés comme la pompe de circulation du liquide caloporteur dans le circuit hydraulique secondaire ou comme l'échangeur de chaleur entre circuits hydrauliques primaire et secondaire, qui soit suffisamment puissant et suffisamment compact pour être intégré avec une efficacité suffisante de refroidissement et un volume réduit dans une armoire informatique contenant déjà une densité élevée de serveurs informatiques laissant donc peu de place pour les modules de refroidissement liquide, tout en garantissant également un niveau de ventilation suffisamment élevé pour son ou ses composants critiques comme sa carte électronique de contrôle, afin de réduire voire d'éviter le risque de surchauffe d'un de ses composants sensibles.

Pour cela, cet autre objet de l'invention propose une disposition particulière des composants les plus importants et les plus volumineux, entre eux ainsi que par rapport à l'écoulement d'air passant à l'intérieur du boîtier extérieur lui-même d'une géométrie plutôt aplatie, tout en maintenant un niveau suffisant de ventilation notamment véhiculée par cet écoulement d'air, avec une simplification de la topologie du circuit hydraulique secondaire associée à ce nouvel agencement interne du module de refroidissement liquide.

Cet autre objet de l'invention propose donc un nouvel agencement interne des composants et une simplification du tracé du circuit hydraulique secondaire pour faciliter le passage de l'écoulement d'air, de manière à améliorer le compromis entre la compacité du module, l'efficacité de sa ventilation interne, et sa puissance de refroidissement pour les serveurs informatiques qui lui sont externes.

A cette fin, cet autre objet de l'invention propose un module de refroidissement liquide de serveur informatique, comprenant un boîtier extérieur intégrant des composants, caractérisé en ce que : le boîtier extérieur présente une longueur, une largeur et une épaisseur telles que, la longueur est inférieure au double de la largeur et l'épaisseur est inférieure à la moitié de la largeur, le boîtier extérieur présente quatre parois latérales, deux dites longues dans le sens de la longueur et deux dites courtes dans le sens de la largeur, un fond et un couvercle, et en ce que le module comprend, parmi les composants intégrés : une pompe orientée dans le sens de la longueur du boîtier extérieur et située le long d'une paroi latérale longue, un ventilateur, un échangeur de chaleur orienté dans le sens de la longueur du boîtier extérieur et situé le long de l'autre paroi latérale longue, au moins deux grilles de ventilation respectivement situées dans les deux parois latérales courtes, un espace longitudinal central dégagé disposé entre la pompe et l'échangeur de manière à y faciliter un écoulement d'air d'une grille d'une paroi latérale courte vers une grille de l'autre paroi latérale courte, cet écoulement d'air étant entraîné par le ventilateur, une portion de circuit hydraulique secondaire, pour la circulation d'un fluide caloporteur, située dans le module de refroidissement liquide, ne comprenant aucune dérivation qui permettrait à la pompe de fonctionner en circuit fermé et qui serait susceptible d'encombrer cet espace longitudinal dégagé, une carte électronique de contrôle disposée dans le prolongement longitudinal de cet espace longitudinal central dégagé de manière à être directement léchée par cet écoulement d'air.

Préférentiellement, le fluide caloporteur est un liquide caloporteur, par exemple de l'eau glycolée. Les circuits hydrauliques primaire et secondaire peuvent aussi contenir respectivement des liquides caloporteurs différents entre eux.

Suivant des modes de réalisation préférés, cet autre objet de l'invention comprend une ou plusieurs des caractéristiques suivantes qui peuvent être utilisées séparément ou en combinaison partielle entre elles ou en combinaison totale entre elles.

De préférence, ladite carte électronique comprend deux parties séparables qui sont d'une part une partie logique démontable sans démontage du module de refroidissement et d'autre part une partie connexion fixée sur le module de refroidissement sans en être séparément démontable, à laquelle partie connexion (de la carte électronique) sont reliées toutes les connexions des composants du module de refroidissement liquide aboutissant à ladite carte électronique. Ainsi, la maintenance de la carte électronique est facilitée, le plus grand nombre de pannes potentielles étant susceptible de se produire sur la partie logique plutôt que sur la partie connexion. La maintenance du composant critique que constitue la carte électronique, dans un module de refroidissement liquide compact, est habituellement difficile et nécessitera souvent un démontage important du module de refroidissement, avec l'ouverture complète du boîtier extérieur requérant par exemple d'enlever complètement le couvercle de ce boîtier extérieur, voire de devoir démonter d'autres composants hors du boîtier extérieur.

De préférence, l'épaisseur du boîtier extérieur est inférieure au tiers de la largeur du boîtier extérieur. Le boîtier extérieur est plus aplati, et prend moins de place. Avantageusement, pour loger les composants clés de la puissance suffisante, l'épaisseur du boîtier extérieur est supérieure au sixième de la largeur du boîtier extérieur, voire supérieure au cinquième de la largeur du boîtier extérieur : elle vaut préférentiellement environ le quart de la largeur du boîtier extérieur.

De préférence, la pompe orientée dans le sens de la longueur du boîtier extérieur et située le long d'une paroi latérale longue est disposée tout contre cette paroi latérale longue. Ainsi, l'espace longitudinal central est mieux dégagé, sans diminuer l'efficacité de la pompe.

De préférence, l'échangeur de chaleur orienté dans le sens de la longueur du boîtier extérieur et situé le long de l'autre paroi latérale longue, est disposé tout près de cette autre paroi latérale longue sans aucun autre élément entre eux qu'une canalisation. Ainsi, l'espace longitudinal central est mieux dégagé, sans diminuer l'efficacité de l'échangeur, en laissant par ailleurs juste l'espace suffisant pour une largeur de canalisation de circuit hydraulique secondaire entre cet échangeur et cette autre paroi latérale longue.

De préférence, ladite carte électronique ne comprend pas de cache de protection et est directement en contact avec tout l'écoulement d'air provenant de l'espace longitudinal central dégagé. Ainsi, la ventilation de la carte électronique est améliorée et un gain supplémentaire de place obtenu. La simplification du circuit hydraulique secondaire a diminué fortement le risque de fuite de liquide caloporteur sur la carte électronique.

De préférence, ladite carte électronique dissipe une puissance calorique d'au moins 5W, de préférence d'au plus 20W, encore plus de préférence comprise entre 7 et 10W. Ainsi, son besoin de ventilation est supérieur, et l'agencement interne du module de refroidissement liquide selon cet autre objet de l'invention d'autant plus intéressante.

La longueur du boîtier extérieur est bien sûr supérieure à sa largeur elle-même bien sûr supérieure à son épaisseur. De préférence, le boîtier extérieur présente une longueur entre 60 et 90cm, une largeur entre 50 et 70cm, une épaisseur entre 10 et 20cm, et de préférence présente une longueur entre 70 et 80cm, une largeur entre 55 et 65cm, une épaisseur entre 13 et 17cm. Cette géométrie de boîtier extérieur est favorable à une disposition bien répartie des principaux composants permettant de mieux dégager un espace longitudinal central pour l'écoulement d'air. Le boîtier extérieur présente par exemple une longueur de 76cm, une largeur de 59.5cm, une épaisseur de 15cm.

De préférence, la pompe possède une puissance suffisante pour présenter une pression différentielle comprise entre 2.5 et 3.5 bars à un débit compris entre 50 et 100 litres de fluide caloporteur par minute.

De préférence, le module de refroidissement dissipe une puissance calorique d'au moins 50kW, de préférence d'au moins 60kW.

Ainsi, seulement deux modules de refroidissement liquide avec un module supplémentaire en redondance suffisent à refroidir une armoire informatique de taille usuelle, contenant une bonne densité de serveurs informatiques.

De préférence, la pompe comprend un guide d'air canalisant l'air entre d'une part la grille de ventilation d'entrée d'air dans le module de refroidissement et d'autre part l'entrée de la pompe. Ainsi, cela évite de réinjecter de l'air devenu chaud en circulant à l'intérieur du boîtier extérieur du module directement à l'entrée de la pompe, ce qui sinon aurait pour conséquence une moins bonne dissipation de la chaleur produite par le moteur de cette pompe.

De préférence, le module de refroidissement comprend un clapet anti-retour situé sur le tronçon de circuit hydraulique secondaire situé entre la sortie de la pompe et l'entrée de l'échangeur de chaleur. En cas de défaillance de la pompe du module de refroidissement liquide, cela évite une circulation forcée de liquide caloporteur dans la portion de circuit hydraulique secondaire de ce module entraînée par la ou les pompes des autres modules de refroidissement liquide.

De préférence, le module de refroidissement comprend une vanne localisée sur une portion de circuit hydraulique primaire située dans le module de refroidissement, ayant pour fonction de réguler indirectement la température de fluide caloporteur dans le circuit hydraulique secondaire en sortie d'échangeur de chaleur, cette vanne étant de préférence une vanne à boisseau sphérique proportionnelle. C'est le principal composant du module de refroidissement liquide qui gère le niveau de refroidissement produit par ce module, en régulant l'arrivée de liquide froid caloporteur dans le circuit hydraulique primaire en provenance de la source froide externe à ce module de refroidissement liquide.

De préférence, l'une des grilles de ventilation est une première grille de ventilation de sortie d'air hors du module de refroidissement et est située juste en aval de ladite carte électronique. Ainsi, la ventilation de la carte électronique est privilégiée, ce qui est intéressant car c'est un composant critique du module de refroidissement liquide, ayant tendance à dissiper beaucoup de chaleur, surtout si une carte électronique puissante à multiples fonctions est choisie.

De préférence, l'une des grilles de ventilation est une deuxième grille de ventilation de sortie d'air hors du module de refroidissement et est située juste en aval de ladite vanne. Ainsi, la ventilation de la vanne laquelle est un autre composant ayant tendance à dissiper beaucoup de chaleur, est également privilégiée.

De préférence, la somme des surfaces des grilles de ventilation de sortie d'air est égale à la surface de la grille de ventilation d'entrée d'air. Ainsi, l'écoulement d'air est mieux fluidisé, l'air s'écoulant au travers de l'intérieur du boîtier extérieur du module, pratiquement sans perte de charge.

De préférence, l'échangeur de chaleur est un échangeur couché sur le côté, de préférence un échangeur à plaques, encore plus de préférence un échangeur à plaques et à flux croisés. Ainsi disposé, l'échangeur naturellement volumineux, rentre sans difficulté dans un boîtier extérieur plutôt aplati. Le type d'échangeur choisi optimise le compromis entre sa puissance fournie et son volume occupé.

De préférence, une couche d'isolation externe entoure d'une part l'échangeur et d'autre part la ou les canalisations d'une portion de circuit hydraulique primaire située dans le module de refroidissement, de manière à éviter la condensation sur leurs parois externes, même lorsque la température desdites parois externes est inférieure à la température de rosée du module de refroidissement. Ainsi, est réduit ou même évité le risque d'écoulement d'eau de condensation qui pourrait avoir deux inconvénients, à savoir d'une part endommager un autre composant du module ou au moins perturber son fonctionnement, et d'autre part éviter de déclencher une fausse alarme au niveau du détecteur de fuite que contient avantageusement le module de refroidissement liquide.

De préférence, le module de refroidissement comprend un détecteur de fuite de liquide localisé dans le fond du boîtier extérieur. Ce détecteur de fuite permet d'émettre une alarme en cas de fuite de liquide caloporteur qui risquerait d'endommager un ou plusieurs composants du module ou au moins de perturber leur fonctionnement. Ce détecteur de fuite déclenche une alarme préférentiellement seulement en cas de fuite notable, les micro-fuites sans incidence et sans risque sur le fonctionnement du module de refroidissement liquide n'étant alors avantageusement pas prises en compte et ne risquant pas d'arrêter sans raison valable le fonctionnement du module de refroidissement liquide.

De préférence, le ventilateur est le ventilateur de la pompe et il est couplé à l'arbre électrique du moteur de la pompe, le moteur de laquelle pompe est alors refroidi par air. Ainsi, ce ventilateur de pompe remplit simultanément deux fonctions, d'une part refroidir le moteur de la pompe, la partie canalisation de la pompe étant refroidie par le passage de liquide caloporteur, et d'autre part entraîner ou faciliter l'entraînement de l'écoulement d'air dans l'espace longitudinal central dégagé situé à l'intérieur du boîtier extérieur du module de refroidissement liquide. En alternative, dans le cas par exemple d'un refroidissement par eau ou autre liquide caloporteur à la fois du moteur de la pompe et du reste de la pompe, la pompe n'ayant alors plus de ventilateur, l'écoulement d'air peut être facilité par le ventilateur d'un autre composant, un ventilateur de taille réduite ajouté à cet effet, ou plus simplement mais moins efficacement dans certains cas par la convection naturelle de l'air entre grilles d'entrée et de sortie.

L'ensemble des différents objets de l'invention, ainsi que toutes leurs réalisations préférentielles, peuvent être combinés entre eux.

D'autres caractéristiques et avantages de l'invention et des autres objets de l'invention apparaîtront à la lecture de la description qui suit d'un mode de réalisation préféré de l'invention, donnée à titre d'exemple et en référence aux dessins annexés.

### BREVE DESCRIPTION DES DESSINS

La figure 1 représente très schématiquement un exemple d'armoire informatique selon un mode de réalisation de l'invention.
La figure 2 représente schématiquement un exemple de structure de circuits hydraulique primaire et secondaire dans les modules de refroidissement liquide d'une armoire informatique selon un mode de réalisation de l'invention.
Les figures 3 et 4 représentent schématiquement un exemple de communication entre différents modules de refroidissement liquide d'une même armoire informatique lors d'une phase d'initialisation selon un mode de réalisation de l'invention.
La figure 5 représente schématiquement un exemple de diagramme de fonctionnement d'un module de refroidissement liquide communiquant avec les autres modules de refroidissement liquide de la même armoire informatique selon un protocole collaboratif de communication selon un mode de réalisation de l'invention.
La figure 6 représente l'agencement interne d'un exemple de module de refroidissement liquide compact selon un mode de réalisation de l'invention.

### DESCRIPTION DETAILLEE DE L'INVENTION

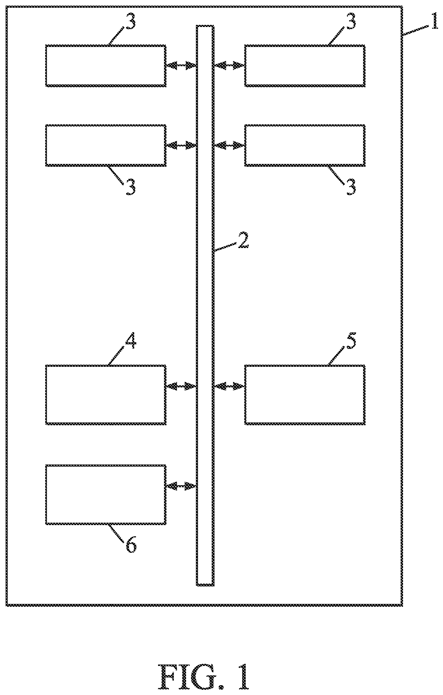

La figure 1 représente très schématiquement un exemple d'armoire informatique selon un mode de réalisation de l'invention.

Une armoire informatique 1 contient un bus Ethernet 2 sur lequel communiquent d'une part un ou préférentiellement plusieurs serveurs informatiques 3 et d'autre part des modules de refroidissement liquide 4, 5 et 6. Par exemple, lors du fonctionnement des serveurs informatiques 3 réalisant par exemple une ou plusieurs calculs, en coopération entre eux ou séparément, les modules de refroidissement 4 et 5 sont en fonctionnement et refroidissent les serveurs informatiques 3, tandis que le module de refroidissement 6 est redondant, c'est-à-dire au repos mais prêt à prendre le relais et à remplacer immédiatement, sans intervention d'un opérateur externe à l'armoire informatique 1, l'un des autres modules de refroidissement 5 ou 6, si celui-ci devenait défaillant.

Le ou les serveurs informatiques 3 sont montés sur un bâti de l'armoire informatique 1 et sont traversés par un circuit hydraulique secondaire de refroidissement véhiculant un fluide ou un liquide caloporteur de forte capacité calorifique bien supérieure à celle de l'air, ce fluide ou liquide caloporteur étant en provenance des modules de refroidissement en fonctionnement qui sont les modules 4 et 5.

Le réseau Ethernet 2 permet la communication entre les contrôleurs de chacun des modules de refroidissement 4 à 6. Ainsi, une panne au niveau de ce réseau 2 entraîne un mode de fonctionnement dégradé de ce système de refroidissement par ailleurs robuste, notamment en cas de panne de l'un des modules de refroidissement 4 ou 5, le module de refroidissement redondant 6 remplaçant immédiatement le module de refroidissement défaillant, par exemple le module 4.

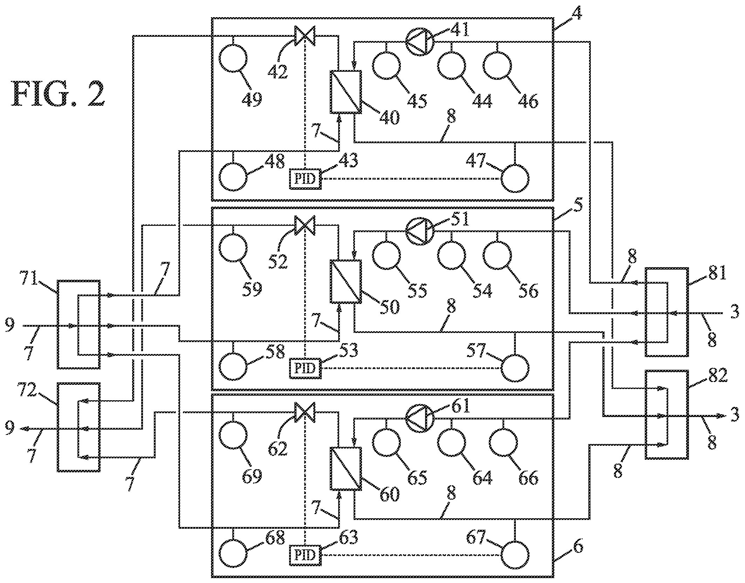

La figure 2 représente schématiquement un exemple de structure de circuits hydraulique primaire et secondaire dans les modules de refroidissement liquide d'une armoire informatique selon un mode de réalisation de l'invention.

Un circuit hydraulique primaire 7 alimente les trois modules de refroidissement liquide 4 à 6 en liquide caloporteur froid issu d'une source froide 9 externe aux modules de refroidissement liquide 4 à 6. Les modules de refroidissement liquide 4 à 6 renvoient vers cette source froide 9 du liquide caloporteur réchauffé par sa traversée des modules de refroidissement liquide 4 à 6. La source froide 9 refroidit à nouveau ce liquide caloporteur qui recommence un autre tour dans le circuit hydraulique primaire 7. Le circuit hydraulique primaire 7, en provenance de la source froide 9, est divisé par un diviseur 71 en trois branches de circuit hydraulique primaire 7 parallèles entre elles et traversant respectivement les trois modules de refroidissement liquide 4 à 6. A la sortie des trois modules de refroidissement liquide 4 à 6, un coupleur 72 regroupe ces trois branches de circuit hydraulique primaire 7 parallèles entre elles pour reconstituer le circuit hydraulique primaire 7 allant vers la source froide 9.

Ces trois modules de refroidissement liquide 4 à 6 alimentent à leur tour les serveurs informatiques 3 en liquide caloporteur refroidi. Les serveurs informatiques 3 renvoient vers les modules de refroidissement liquide 4 à 6 du liquide caloporteur réchauffé par l'énergie thermique dissipée par ces serveurs informatiques 3 et évacuée par ce liquide caloporteur. Les modules de refroidissement liquide 4 à 6 refroidissent à nouveau ce liquide caloporteur qui recommence un autre tour dans le circuit hydraulique secondaire 8. Le circuit hydraulique secondaire 8, en provenance des serveurs informatiques 3, est divisé par un diviseur 81 en trois branches de circuit hydraulique secondaire 8 parallèles entre elles et traversant respectivement les trois modules de refroidissement liquide 4 à 6. A la sortie des trois modules de refroidissement liquide 4 à 6, un coupleur 82 regroupe ces trois branches de circuit hydraulique secondaire 8 parallèles entre elles pour reconstituer le circuit hydraulique secondaire 8 allant vers les serveurs informatiques 3.

Le circuit hydraulique primaire 7 et le circuit hydraulique secondaire 8 ne sont pas en contact fluidique, c'est-à-dire que les liquides caloporteurs de ces deux circuits hydrauliques ne se mélangent pas entre eux. Le circuit hydraulique primaire 7 et le circuit hydraulique secondaire 8 sont en contact thermique, c'est-à-dire que les liquides caloporteurs de ces deux circuits hydrauliques échangent de la chaleur entre eux, lors de leur traversée des échangeurs 40, 50 et 60 des modules de refroidissement liquide 4 à 6.

Le module de refroidissement 4 comprend un échangeur 40, une pompe 41, une vanne 42, un asservissement 43 de type PID (proportionnel-intégrateur-dérivateur), un capteur de pression amont 44, un capteur de pression aval 45, un capteur de température secondaire amont 46, un capteur de température secondaire aval 47, un capteur de température primaire amont 48, un capteur de température primaire aval 49.

Le liquide caloporteur froid d'une branche du circuit hydraulique primaire 7 entre dans le module de refroidissement liquide 4, traverse l'échangeur 40 où il est réchauffé par échange thermique avec le liquide caloporteur chaud d'une branche du circuit hydraulique secondaire 8, traverse la vanne 42 dont l'ouverture régule son débit à travers le module de refroidissement liquide 4, puis ressort du module de refroidissement liquide 4. La température de ce liquide caloporteur froid est mesurée juste après son entrée dans le module de refroidissement liquide 4 par le capteur de température primaire amont 48. La température de ce liquide caloporteur réchauffé est mesurée juste avant sa sortie du module de refroidissement liquide 4 par le capteur de température primaire aval 49. Le pompage d'entraînement du liquide caloporteur dans le circuit hydraulique primaire 7 est effectué par une ou plusieurs pompes situées à l'extérieur des modules de refroidissement liquide 4 à 6, et éventuellement partagées par les modules de refroidissement liquide de plusieurs armoires informatiques différentes. Les températures mesurées par les capteurs de température primaire 48 et 49 permettent de vérifier le fonctionnement correct du circuit hydraulique primaire 7.

Le liquide caloporteur chaud d'une branche du circuit hydraulique secondaire 8 entre dans le module de refroidissement liquide 4, est entraîné par la pompe 41, traverse l'échangeur 40 où il est refroidi par échange thermique avec le liquide caloporteur froid d'une branche du circuit hydraulique primaire 7, puis ressort du module de refroidissement liquide 4.

La température de ce liquide caloporteur chaud est mesurée juste après son entrée dans le module de refroidissement liquide 4 par le capteur de température secondaire amont 46. La température de ce liquide caloporteur réchauffé est mesurée juste avant sa sortie du module de refroidissement liquide 4 par le capteur de température secondaire aval 47. Les températures mesurées par les capteurs de température secondaire 46 et 47 permettent de vérifier le fonctionnement correct du circuit hydraulique secondaire 8. Le circuit secondaire 8 assure la circulation du liquide de refroidissement ou liquide caloporteur, dans la boucle interne à l'armoire informatique, à une température comprise entre 20°C et 45°C. Le capteur de température 47 est apte à mesurer la température en sortie du circuit hydraulique secondaire 8 du module de refroidissement 4, le débit du liquide caloporteur du circuit hydraulique primaire 7 étant maintenu à un débit choisi pour que la température en sortie du circuit hydraulique secondaire 8 soit égale à une température seuil. La température en entrée du circuit secondaire 8 de refroidissement qui traverse les serveurs informatiques 3, mesurée par le capteur de température secondaire amont 46, est maintenue constante pour optimiser le refroidissement des composants électroniques de leurs lames de calcul. La régulation en température est autonome pour chacun des modules de refroidissement liquide 4 à 6, pour assurer une température constante en entrée des serveurs informatiques quelle que soit leur dissipation thermique.

Le circuit hydraulique primaire 7 concerne les circuits reliés au réseau hydraulique de l'infrastructure du client utilisateur du cluster informatique regroupant l'ensemble des armoires informatiques par exemple dans une salle informatique, et le circuit hydraulique secondaire 8 concerne les circuits hydrauliques reliés au circuit de refroidissement de l'armoire informatique. Le module de refroidissement 4 comporte une portion de circuit hydraulique primaire 7 comportant une sortie apte à être reliée à l'entrée d'un réseau hydraulique primaire client et une entrée apte à être reliée à la sortie du réseau hydraulique primaire 7 client. Le module de refroidissement 4 comporte aussi une portion de circuit hydraulique secondaire 8 comportant une sortie reliée à l'entrée du circuit de refroidissement secondaire 8 de l'armoire informatique et une entrée reliée à la sortie du circuit de refroidissement secondaire 8 de l'armoire informatique.

Par ailleurs, dans l'armoire informatique, l'entrée et la sortie du circuit hydraulique primaire 7 de chaque module de refroidissement 4 à 6 sont pourvues de connecteurs rapides anti-gouttes permettant de connecter et de déconnecter facilement la portion de circuit hydraulique primaire 7 des modules de refroidissement 4 à 6 au reste du réseau hydraulique primaire 7 de la salle informatique du cluster informatique.

La pression du liquide caloporteur dans la branche du circuit hydraulique secondaire 8 est mesurée juste en amont de la pompe 41 par le capteur de pression amont 44, ainsi que juste en aval de la pompe 41 par le capteur de pression aval 45, afin de contrôler le bon fonctionnement de la pompe 41, et afin de pouvoir arrêter la pompe 41 en cas de dysfonctionnement de celle-ci. La pompe 41 présente une puissance suffisante pour faire circuler le liquide de refroidissement secondaire dans la boucle interne à une pression d'environ 3 bars à un débit d'environ 75 litres par minute de liquide de refroidissement secondaire qui est par exemple de l'eau glycolée. La pompe 41 débite un débit constant sans fluctuations de pression génératrices de vibrations grâce à la forme des conduits des canalisations de la portion de circuit hydraulique secondaire 8 située dans le module de refroidissement 4. La pompe 41, qui est apte à contrôler le débit du fluide caloporteur dans le circuit hydraulique secondaire 8, est associée à des moyens de commande aptes à commander cette pompe 41. Le liquide caloporteur dans le circuit secondaire 8 de refroidissement présente de préférence une pression statique supérieure ou égale à 2 bars. Le fait de maintenir ce liquide caloporteur sous pression permet à la pompe 41 d'être protégée de tout risque de cavitation, et au système de refroidissement de l'armoire informatique de fonctionner y compris en cas de fuite.

L'entrée et la sortie du circuit hydraulique secondaire 8 de chaque module de refroidissement 4 à 6 sont pourvues de connecteurs rapides anti-goutte permettant de connecter et de déconnecter facilement la portion de circuit hydraulique secondaire 8 des modules de refroidissement 4 à 6 au reste du circuit hydraulique secondaire 8 de l'armoire informatique refroidissant les serveurs informatiques 3.

Dans l'échangeur 40, 60 kW de chaleur sont échangées entre le circuit hydraulique secondaire 8 qui les donne et le circuit hydraulique primaire 7 qui les prend, par l'intermédiaire d'un échangeur 40 à plaques, de taille suffisante pour échanger cette puissance avec des débits similaire ou identiques, ou au moins du même ordre de grandeur, des deux côtés et une température d'approche de 4°C, cette température d'approche correspondant à la différence entre la température amont externe mesurée par le capteur de température primaire amont 48 la température aval interne mesurée par le capteur de température secondaire aval 47. L'échangeur de chaleur 40 est apte à refroidir le fluide caloporteur traversant le circuit hydraulique secondaire 8 par dissipation de chaleur à travers le circuit hydraulique primaire 7.

L'asservissement 43 régule l'ouverture de la vanne 42, et donc le débit du liquide caloporteur du circuit hydraulique primaire 7 dans le module de refroidissement liquide 4, en fonction de la température du liquide caloporteur du circuit hydraulique secondaire 8 en sortie du module de refroidissement liquide 4, mesurée par le capteur de température secondaire aval 47.

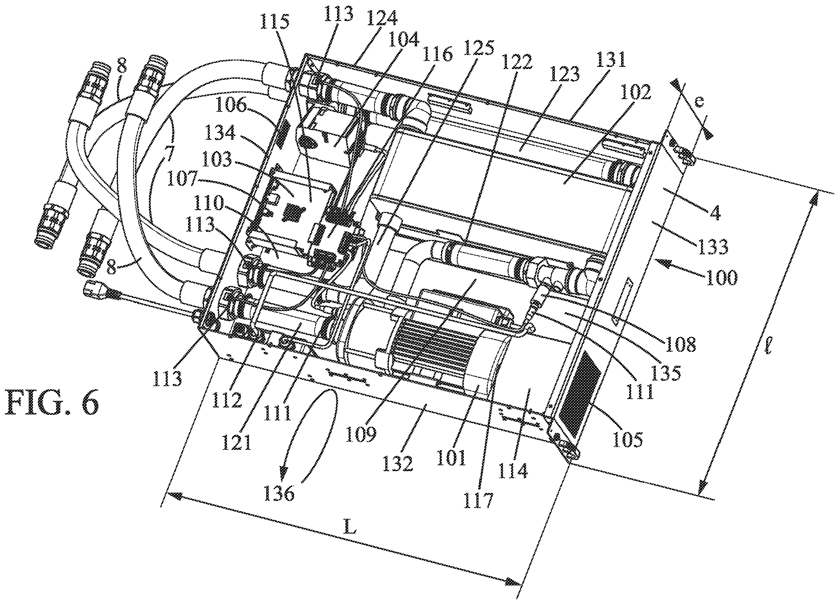

Le module de refroidissement liquide 4 comprend aussi des moyens de contrôle du bon fonctionnement du module 4 et de détection des pannes, ainsi que des moyens de contrôle de la bonne régulation en température du fluide caloporteur traversant le circuit hydraulique secondaire 8, qui sont notamment les différents capteurs de température et de pression associées à une carte électronique représentée sur la figure 6 ci-après. Le refroidissement de la carte électronique de contrôle de chaque module de refroidissement liquide est réalisé par le ventilateur chargé de refroidir le moteur de la pompe de ce module de refroidissement liquide.

Le module de refroidissement 5 comprend un échangeur 50, une pompe 51, une vanne 52, un asservissement 53 de type PID (proportionnel-intégrateur-dérivateur), un capteur de pression amont 54, un capteur de pression aval 55, un capteur de température secondaire amont 56, un capteur de température secondaire aval 57, un capteur de température primaire amont 58, un capteur de température primaire aval 59. Le module de refroidissement 5 est identique au module de refroidissement 4. Le module de refroidissement 5 fonctionne de manière identique à celle du module de refroidissement 4.

Le module de refroidissement 6 comprend un échangeur 60, une pompe 61, une vanne 62, un asservissement 63 de type PID (proportionnel-intégrateur-dérivateur), un capteur de pression amont 64, un capteur de pression aval 65, un capteur de température secondaire amont 66, un capteur de température secondaire aval 67, un capteur de température primaire amont 68, un capteur de température primaire aval 69. Le module de refroidissement 6 est identique au module de refroidissement 4. Le module de refroidissement 6 fonctionne de manière identique à celle du module de refroidissement 4.

Les trois modules de refroidissement 4 à 6 peuvent fonctionner en redondance de base, c'est-à-dire avec trois modules actifs avec passage à deux modules actifs lors de la panne ou du retrait d'un de ces modules. Le mode de fonctionnement en régime particulier comme par exemple lors de l'initialisation du système de refroidissement est le fonctionnement en redondance de base.

Les trois modules de refroidissement 4 à 6 peuvent fonctionner en redondance optimisée, c'est-à-dire avec deux modules actifs 4 et 5 et un module 6 en réserve, prêt à démarrer si un des deux modules actifs 4 ou 5 est arrêté à la suite d'une panne ou du retrait de ce module. Le mode de fonctionnement en régime normal ou de croisière est le fonctionnement en redondance optimisée.

Ce fonctionnement en redondance de base et/ou en redondance optimisée peut bien sûr être généralisé avec n modules de refroidissement liquide, n étant alors strictement supérieur à deux.

Il n'y a pas de rupture de service lors de l'arrêt ou du démarrage d'un des n modules de refroidissement liquide. Chacun des n modules de refroidissement liquide est démontable pour permettre la maintenance sans arrêter le refroidissement des serveurs informatiques 3 présents dans l'armoire informatique.

La régulation et la détection de pannes est réalisée par la surveillance de capteurs de température 46 à 49, 56 à 59 ou 66 à 69 et de capteurs de pression 44 et 45, ou 54 et 55 ou 65 et 66, grâce à une carte électronique propre à chaque module de refroidissement 4, 5 ou 6.

Le dialogue entre les cartes des trois modules de refroidissement liquide 4 à 6 s'effectue par l'intermédiaire du protocole TCP (« Transmission Control Protocol / Internet Protocol » en langue anglaise) ou du protocole UDP (« User Datagram Protocol » en langue anglaise). Les trois modules de refroidissement liquide 4 à 6 effectuent également l'envoi de messages au standard SNMP (« Simple Network Management Protocol » en langue anglaise) vers un système général de surveillance de l'armoire et de gestion de la salle informatique regroupant plusieurs armoires informatiques. Entre les trois modules de refroidissement liquide 4 à 6, il n'y a pas de système maître/esclave, car la perte du contrôleur maître entraînerait alors la perte du système de refroidissement dans son ensemble, ce que l'invention cherche à éviter en le rendant plus robuste aux pannes.

Le changement de module de refroidissement liquide au repos est programmé pour vérifier sa disponibilité en tant que module de refroidissement liquide redondant, c'est-à-dire du module de refroidissement liquide de secours, pour qu'il soit opérationnel en cas d'urgence.

Un nombre suffisant de modules de refroidissement liquide sont actifs en même temps en permanence, pour fournir la quantité suffisante de débit du liquide caloporteur aux serveurs informatiques 3 ; ici les modules de refroidissement liquide 4 et 5 fonctionnent tandis que le module de refroidissement liquide 6 est au repos, gardé en réserve.

Les modules de refroidissement 4 à 6 permettent de fournir le liquide caloporteur à une température constante maximale pour chacune des lames de calcul incluses dans les serveurs informatiques 3 montés sur le bâti de l'armoire informatique.

Deux, ou bien n strictement supérieur à deux dans le cas d'une généralisation, des modules de refroidissement liquide 4 et 5 sont actifs, tandis que l'autre module de refroidissement liquide 6 est actif ou inactif, selon le mode de redondance possible choisi qui peut être une redondance de base ou bien préférentiellement une redondance optimisée. Ainsi, si un des modules de refroidissement liquide actifs 4 ou 5 présente un dysfonctionnement, le contrôleur du module de refroidissement liquide 6 inactif en est informé par le réseau 2 et démarre son module de refroidissement liquide 6, de sorte que l'armoire informatique est toujours refroidie par au moins deux modules de refroidissement liquide. Ainsi, même en cas de panne ou de maintenance d'un des modules de refroidissement liquide, l'armoire informatique peut continuer à fonctionner normalement ; toutefois en cas improbable de deuxième panne avant réparation de la première panne, consistant essentiellement dans l'échange standard du module de refroidissement liquide défaillant, le refroidissement va bien sûr se dégrader.

Les modules de refroidissement liquide 4 à 6 sont démontables en cas de maintenance sans arrêter le refroidissement des serveurs informatiques 3. Les modules de refroidissement liquide 4 à 6 permettent de réguler le liquide caloporteur en température, pour assurer une température constante en entrée des serveurs informatiques 3 quelle que soit leur dissipation thermique.

De plus, les modules de refroidissement 4 à 6 sont aptes à détecter des pannes par la surveillance de capteurs de pression et de température grâce à des moyens de commande propres à chaque module de refroidissement liquide. Les composants hydrauliques du module de refroidissement sont optimisés, d'une part, en consommation de pertes de charge, afin de minimiser l'énergie hydraulique que la pompe 41 doit fournir et en optimiser ainsi sa dimension et sa consommation électrique, d'autre part, en termes d'encombrement afin d'améliorer la compacité du module de refroidissement liquide. Le système de refroidissement selon un mode de réalisation préférentiel de l'invention permet de dissiper 120 kW pour deux modules de refroidissement liquide 4 et 5 actifs.

Les modules de refroidissement liquide 4 à 6 sont identiques entre eux pour être interchangeables et être remplacés par un module de rechange stocké sur place dans la salle informatique ou à proximité. Un module de refroidissement liquide en panne devrait être réparé sur un autre site, il est fortement déconseillé d'ouvrir le module de refroidissement liquide sur le site de la salle informatique. Des modules de refroidissement liquide de rechange sont disponibles sur site.

La seule opération de maintenance autorisée sur site est la dépose du module de refroidissement liquide défaillant et son remplacement par un module de refroidissement liquide de rechange en quelques minutes, sans rupture de service au niveau des serveurs informatiques 3 de l'armoire informatique.

Le fonctionnement d'un module de refroidissement liquide, et donc le bon refroidissement du système de refroidissement liquide, n'est pas ou peu affecté par la présence ou non du module supplémentaire de redondance 6, ou bien par le fonctionnement en mode autonome, lequel est un mode de fonctionnement dégradé, ou non du module de refroidissement liquide supplémentaire 6.

Les effets des connexions et déconnexions lors de la maintenance sont gérés par les contrôleurs de chaque module de refroidissement liquide 4 à 6 pour atténuer les effets transitoires et maintenir le bon refroidissement des serveurs informatiques 3 de l'armoire informatique.

Avantageusement, ces trois modules de refroidissement 4 à 6 sont placés dans une partie inférieure de l'armoire informatique, les serveurs informatiques 3 étant placés dans une partie supérieure de cette même armoire informatique. La partie inférieure est située sous la partie supérieure, lorsque l'armoire informatique est installée (debout) en fonctionnement.

Le fait d'avoir les modules de refroidissement 4 à 6 sous les serveurs informatiques 3 permet d'éviter qu'en cas de fuite importante du liquide caloporteur dans un des modules de refroidissement 4 à 6, ce fluide caloporteur ne coule sur les serveurs informatiques 3.

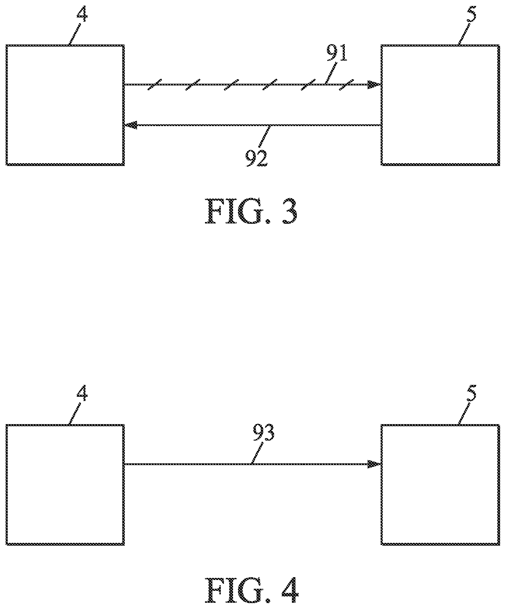

Les figures 3 et 4 représentent schématiquement un exemple de communication entre différents modules de refroidissement liquide d'une même armoire informatique lors d'une phase d'initialisation selon un mode de réalisation de l'invention.

Sur la figure 3, un premier module de refroidissement liquide 4 diffuse des données représentatives de son identité par une diffusion 91 par un protocole de diffusion UDP (« Broadcast UDP » en langue anglaise). Le message 91 comprend l'identifiant du premier module de refroidissement, un identifiant de son groupe de modules de refroidissement inclus dans son armoire de refroidissement, son adresse Internet. Un deuxième module de refroidissement 5 recevant cette diffusion 91 renvoie au premier module de refroidissement liquide 4 un message ciblé 92 qui contient d'une part ses propres données représentatives de sa propre identité et d'autre part un accusé de réception de la diffusion 91. Le message 92 comprend un accusé de réception du message 91, l'identifiant du deuxième module de refroidissement, un identifiant de son groupe de modules de refroidissement inclus dans son armoire de refroidissement (qui est donc le même que celui du premier module de refroidissement), son adresse Internet (l'adresse Internet du deuxième module de refroidissement). C'est une première phase d'identification qui est réalisée préalablement à la phase de communication et d'échange de données décrite sur la figure 4 ci-après. Cette première phase d'identification est effectuée en mode diffusion par l'intermédiaire d'un protocole TCP ou d'un protocole UDP. La table des adresses Internet des modules de refroidissement de ce groupe peut être construite localement chez chacun de ces modules de refroidissement, permettant ensuite au procédé d'échange d'informations de mise à jour de leur état en fonctionnement de se dérouler. Cette diffusion est effectuée par chacun des modules de refroidissement plusieurs fois pendant une durée de 2 minutes, puisqu'elle est une communication asynchrone, pour permettre aux autres modules de refroidissement liquide de recevoir cette diffusion. Chacun des modules de refroidissement agit alors à la fois comme un émetteur de données de type client et comme un récepteur de données de type serveur.

Sur la figure 4, le premier module de refroidissement liquide 4 envoie, à destination des autres modules de refroidissement liquide 5 et 6 de l'armoire informatique commune, de manière périodique, un message ciblé 93 contenant d'une part un rappel de ses données représentatives de son identité et une mise à jour de certains paramètres de son fonctionnement. Chacun des autres modules de refroidissement liquide 5 et 6 fait la même chose, c'est-à-dire envoie, à destination des autres modules de refroidissement liquide de l'armoire informatique commune, de manière périodique, le même message ciblé 93 contenant d'une part un rappel de ses données représentatives de son identité et une mise à jour de certains paramètres de son fonctionnement. La période retenue est ici une seconde. La structure des données échangées est la suivante et peut comprendre dans l'ordre : l'identifiant de leur groupe commun, l'identifiant du module de refroidissement, une ou plusieurs variables d'état, une ou plusieurs paramètres de refroidissement, une ou plusieurs variables de refroidissement. Le module de refroidissement modifie ses variables d'état en fonction de son environnement. Le statut de l'armoire informatique est construit par le système général de contrôle et de supervision de l'ensemble des armoires informatiques, c'est-à-dire par le système général de contrôle et de supervision du cluster informatique. Pour cela ce système général de contrôle et de supervision peut interroger chaque module de refroidissement, par exemple à l'aide de commandes IPMI (« Intelligent Platform Management Interface » en langue anglaise) périodiquement, par exemple chaque seconde. Alternativement, un script extérieur à l'armoire informatique peut interroger périodiquement, par exemple chaque seconde, les différents modules de refroidissement.

Chacun des modules de refroidissement liquide 4 à 6 fonctionne de manière autonome et régule son fonctionnement sans qu'aucun des modules de refroidissement liquide 4 à 6 ne joue le rôle d'un maître dirigeant les autres modules comme des esclaves, grâce au protocole de communication collaboratif entre les modules de refroidissement liquide 4 à 6. Chacun des modules de refroidissement liquide 4 à 6 peut démarrer tout seul. Chacun des modules de refroidissement liquide 4 à 6 connaît la topologie de son armoire informatique et donc du groupe de modules de refroidissement liquide associés, ainsi que son identifiant de groupe, ainsi que sa position au sein de ce groupe, toutes ces informations lui étant communiquées par un autre réseau informatique lorsque le procédé de démarrage de l'armoire informatique est lancé. Le module de refroidissement connaît son identifiant de groupe et sa position dans ce groupe indépendamment de son adresse Internet laquelle lui est communiquée par le protocole DHCP (« Dynamic Host Configuration Protocol » en langue anglaise).

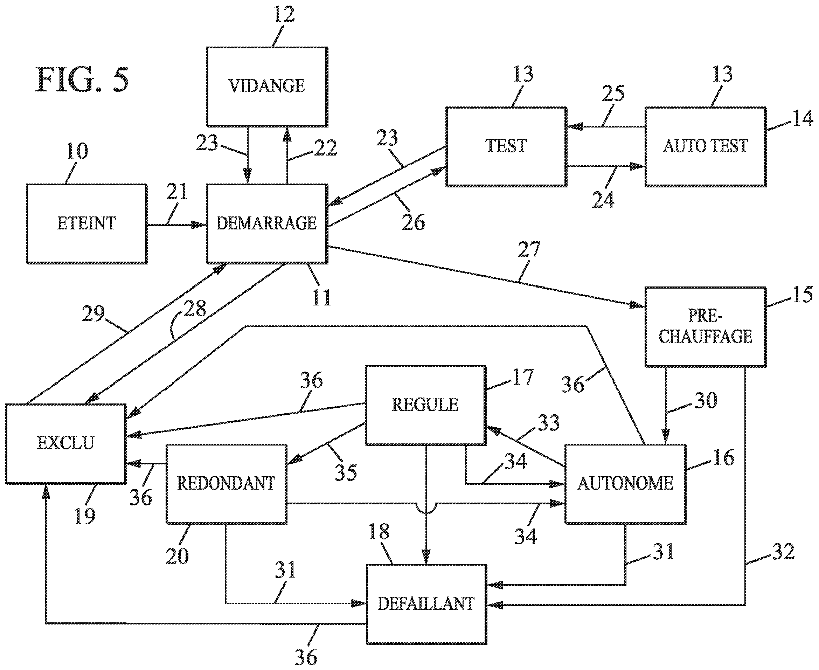

La figure 5 représente schématiquement un exemple de diagramme de fonctionnement d'un module de refroidissement liquide communiquant avec les autres modules de refroidissement liquide de la même armoire informatique selon un protocole collaboratif de communication selon un mode de réalisation de l'invention.

Les modules de refroidissement communiquent entre eux par un protocole collaboratif, sans maître ni esclave, ils sont amenés à prendre leurs décisions le plus souvent à l'unanimité, parfois à la majorité.

Le module de refroidissement peut prendre différent états ou statuts, parmi lesquels un état éteint 10, un état démarrage 11, un état vidange 12, un état test 13, un état autotest 14, un état préchauffage 15, un statut autonome 16, un statut régulé 17, un statut défaillant 18, un statut exclu 19, un statut redondant 20.

Dans l'état éteint 10, le module de refroidissement est hors tension électrique.

Dans l'état démarrage 11, le module de refroidissement est mis sous tension électrique et il effectue son démarrage.

Dans l'état vidange 12, le module de refroidissement effectue une maintenance permettant notamment de vider l'eau de la portion du circuit primaire du module de refroidissement.

Dans l'état test 13, le module de refroidissement effectue un test de vérification de son bon fonctionnement. Une fois le test de vérification terminé au niveau de l'usine du fabricant de module de refroidissement, ce module de refroidissement va être mis dans le statut exclu 19, avec des valeurs par défaut des paramètres de refroidissement. Un nouveau module de refroidissement ou un module de refroidissement de réserve sera par principe mis dans le statut exclu 19. Après l'introduction manuelle d'un module de refroidissement dans l'armoire informatique, ce module de refroidissement va commencer dans le statut exclu 19 et va y rester jusqu'à nouvel ordre. Ensuite, l'opérateur extérieur va ensuite contrôler les paramètres de refroidissement de ce module de refroidissement avec ceux des autres modules de refroidissement présents dans l'armoire informatique commune car appartenant au même groupe de modules de refroidissement. C'est seulement après cette phase de contrôle, que ce module de refroidissement va pouvoir être inclus au sein de ce groupe de modules de refroidissement. Pendant que ce module de refroidissement reste dans le statut exclu 19, c'est la valeur de son propre identifiant qui va rester affectée à son paramètre de module de refroidissement redondant.

Dans l'état autotest 14, le module de refroidissement effectue lui-même un test de vérification de son bon fonctionnement.

Dans l'état préchauffage 15, le module de refroidissement effectue un préchauffage.

Dans le statut autonome 16, le module de refroidissement refroidit correctement mais il n'est pas encore synchronisé avec les autres modules de refroidissement. Si au moins l'un des modules de refroidissement réussit à passer au statut autonome 16, alors l'armoire informatique est mise sous tension électrique ainsi que l'ensemble des serveurs informatiques qu'elle contient.

Dans le statut régulé 17, le module de refroidissement refroidit correctement et il est déjà synchronisé avec les autres modules de refroidissement.

Dans le statut défaillant 18, le module de refroidissement ne fonctionne plus correctement et ne refroidit plus correctement, il est en panne. Dans le statut défaillant 18, le module de refroidissement va mettre hors tension électrique sa pompe, notamment dans deux cas, lorsque le risque de condensation devient trop élevé, ou lorsque la pression dans le circuit secondaire devient trop faible. Avant de passer dans le statut défaillant 18, le module de refroidissement va envoyer une alerte qui sera reçue par le gestionnaire général supervisant les armoires informatiques du cluster informatique. Lorsque tous les modules de refroidissement sont dans le statut défaillant 18, le gestionnaire général supervisant l'armoire informatique peut donc constater qu'ils sont tous dans le statut défaillant 18, que toutes les pompes sont arrêtées, que le refroidissement est arrêté, qu'il faut donc mettre hors tension l'ensemble de l'armoire informatique, c'est-à-dire tous les serveurs informatiques qu'elle contient. Tant qu'un module de refroidissement reste dans le statut défaillant 18 et n'est pas passé dans le statut exclu 19, il peut être réinitialisé par un opérateur extérieur à l'armoire informatique. Si, lors de cette réinitialisation, la défaillance 31 n'est pas revenue, ce module de refroidissement va passer d'abord dans le statut autonome 16 puis éventuellement dans le statut régulé 17. Si, lors de cette réinitialisation, la défaillance 31 revient, ce module de refroidissement va passer, sur réception d'une commande d'exclusion 36 de la part d'un opérateur extérieur, au statut exclu 19.

Dans le statut exclu 19, le module de refroidissement est exclu explicitement du groupe de modules de refroidissement. Il lui faudra une commande explicite d'inclusion pour pouvoir être réintégré dans le groupe de modules de refroidissement. Sans cette commande explicite d'inclusion, même une commande de mise sous tension 21 ou de redémarrage 23 n'aura pas pour conséquence sa réintégration au sein de son groupe de modules de refroidissement. La commande de redémarrage 23 peut également être effectuée à partir de pratiquement tous les autres états ou statuts, sauf à partir de l'état éteint 10.

Dans le statut redondant 20. le module de refroidissement est en redondance, c'est-à-dire qu'il est au repos, et qu'il est prêt à basculer dans un statut autonome 16 pour remplacer un autre module de refroidissement de leur groupe commun, refroidir à sa place, si cet autre module de refroidissement soit est passé dans un statut défaillant 18 soit a été mis dans un statut exclu 19.

Le module de refroidissement passe d'un état ou d'un statut à un autre, par l'intermédiaire soit d'une commande d'un opérateur extérieur, soit d'une opération qu'il réalise lui-même lorsque la condition correspondante est remplie.

Parmi ces commandes ou ces opérations, se trouvent une commande alimentation électrique 21, une commande de vidange 22, une commande de redémarrage 23, une commande de début d'autotest 24, une commande de sortie d'autotest 25, une commande de démarrage de test 26, une commande d'alimentation du refroidissement 27, une commande d'exclusion après échec de démarrage 28, une commande d'inclusion 29, une opération de terminaison du préchauffage 30, une défaillance 31, une défaillance du préchauffage 32, une opération de constatation de cohérence des données 33, une opération de constatation d'incohérence des données 34, une opération de basculement vers la redondance 35, une commande d'exclusion 36.

La commande d'alimentation électrique 21 met le module de refroidissement sous tension électrique et lance le démarrage de ce module de refroidissement. La commande d'alimentation électrique 21 fait passer le module de refroidissement d'un état éteint 10 à un état démarrage 11.

La commande de vidange 22 donne l'ordre d'effectuer une maintenance permettant notamment de vider l'eau de la portion du circuit primaire du module de refroidissement. La commande de vidange 22 fait passer le module de refroidissement d'un état démarrage 11 à un état vidange 12.

La commande de redémarrage 23 donne l'ordre au module de refroidissement d'effectuer un redémarrage. La commande de redémarrage 23 fait passer le module de refroidissement d'un état vidange 12 à un état démarrage 11, ou bien d'un état test 13 à un état démarrage 11.

La commande de début d'autotest 24 donne l'ordre au module de refroidissement de commencer un autotest. La commande de début d'autotest 24 fait passer le module de refroidissement d'un état test 13 à un état autotest 14.

La commande de sortie d'autotest 25 donne l'ordre au module de refroidissement d'arrêter l'autotest. La commande de sortie d'autotest 25 fait passer le module de refroidissement d'un état autotest 14 à un état test 13.

La commande de démarrage de test 26 donne l'ordre au module de refroidissement de commencer un test. La commande de démarrage de test 26 fait passer le module de refroidissement d'un état test 13 à un état démarrage 11.

La commande d'alimentation du refroidissement 27 donne l'ordre au module de refroidissement de commencer le préchauffage. La commande d'alimentation du refroidissement 27 fait passer le module de refroidissement d'un état démarrage 11 à un état préchauffage 15.

La commande d'exclusion après échec de démarrage 28 exclut le module de refroidissement de son groupe de modules de refroidissement après un échec de son démarrage. La commande d'exclusion après échec de démarrage 28 fait passer le module de refroidissement d'un état démarrage 11 à un statut exclu 19.

La commande d'inclusion 29 inclut ou inclut de nouveau le module de refroidissement dans son groupe de modules de refroidissement. La commande d'inclusion 29 fait passer le module de refroidissement d'un statut exclu 19 à un état démarrage 11. Lorsque la commande d'inclusion 29 est envoyée à l'un des modules de refroidissement, alors le processus d'inclusion commence lorsque ce module de refroidissement reçoit cette commande d'inclusion 29, préférentiellement sous la forme d'une commande IPMI. Ce module de refroidissement affecte alors la valeur de son propre identifiant à son paramètre de module de refroidissement redondant, ce qui en fait devrait déjà être le cas. Ce module de refroidissement passe à l'état démarrage 11, les paramètres de refroidissement ayant normalement été préalablement initialisés directement par l'opérateur au cours du précédent processus d'exclusion. Si une commande d'alimentation du refroidissement 27 est reçue par ce module de refroidissement, celui-ci va passer au statut autonome 16 d'abord, et au statut régulé 17 ensuite si une opération de constatation de cohérence des données 33 est réalisée. Puis, si l'indicateur de stabilité devient lui aussi positif, alors ce module de refroidissement va passer au statut redondant 20 par une opération de basculement vers la redondance 35.

L'opération de terminaison du préchauffage 30 arrête le préchauffage du module de refroidissement. L'opération de terminaison du préchauffage 30 fait passer le module de refroidissement d'un état préchauffage 15 à un statut autonome 16.

La défaillance 31 est une panne du module de refroidissement. La défaillance 31 fait passer le module de refroidissement à un statut défaillant 18 à partir d'un statut autonome 16, ou bien à partir d'un statut régulé 17, ou bien à partir d'un statut redondant 20. Lorsque la défaillance 31 survient pour l'un des modules de refroidissement, alors ce module de refroidissement affecte la valeur de son propre identifiant à son paramètre de module de refroidissement redondant, envoie une requête aux autres modules de refroidissement leur demandant de mettre leur paramètre de module de refroidissement redondant à la même valeur que lui. Puis, le module de refroidissement redondant, quitte le statut redondant 20 pour passer au statut régulé 17 ou plutôt rapidement au statut autonome 16, car l'indicateur de stabilité va devenir négatif puisque l'un des modules de refroidissement, celui qui vient de passer au statut défaillant 18, n'est plus dans le statut régulé 17.

La défaillance du préchauffage 32 est une panne du module de refroidissement survenant pendant son préchauffage. La défaillance du préchauffage 32 fait passer le module de refroidissement à un statut défaillant 18 à partir d'un état préchauffage 15.

L'opération de constatation de cohérence des données 33 rend positifs ou laisse positifs les indicateurs de cohérence des modules de refroidissement. L'opération de constatation de cohérence des données 33 fait passer le module de refroidissement d'un statut autonome 16 à un statut régulé 17.

L'opération de constatation d'incohérence des données 34 rend négatif ou laisse négatif au moins l'un des indicateurs de cohérence des modules de refroidissement. L'opération de constatation d'incohérence des données 34 fait passer le module de refroidissement à un statut autonome 16 à partir d'un statut régulé 17, ou bien à partir d'un statut autonome 20. Lorsque l'un des modules de refroidissement actifs passe dans le statut défaillant 18, il arrête sa pompe, et le module de refroidissement qui était dans le statut redondant 20 démarre sa pompe de lui-même pour passer au statut autonome 16.

L'opération de basculement vers la redondance 35 met un seul module de refroidissement au repos avec la capacité de se remettre à refroidir immédiatement en cas d'urgence, notamment pour remplacer un autre module de refroidissement devenu défaillant. L'opération de basculement vers la redondance 35 fait passer le module de refroidissement d'un statut régulé 17 à un statut redondant 20.

La commande d'exclusion 36 exclut le module de refroidissement de son groupe de modules de refroidissement. La commande d'exclusion 36 fait passer le module de refroidissement à un statut exclu 19 à partir d'un statut autonome 16, ou bien à partir d'un statut régulé 17, ou bien à partir d'un statut défaillant 18, ou bien à partir d'un statut redondant 20.

Lorsque la commande d'exclusion 36 est envoyée à l'un des modules de refroidissement, alors le processus d'exclusion commence lorsque ce module de refroidissement reçoit cette commande d'exclusion 36, préférentiellement sous la forme d'une commande IPMI. Ce module de refroidissement affecte alors la valeur de son propre identifiant à son paramètre de module de refroidissement redondant, envoie une requête aux autres modules de refroidissement leur demandant de mettre leur paramètre de module de refroidissement redondant à la même valeur que lui. Puis, le module de refroidissement redondant, quitte le statut redondant 20 pour passer soit au statut autonome 16 soit au statut régulé 17.

La commande d'exclusion 36 est, pour le module de refroidissement auquel elle est envoyée, la première étape du processus tendant à retirer un module de refroidissement au statut défaillant 18, hors de l'armoire informatique, pour effectuer une maintenance de ce module de refroidissement.

En régime normal de fonctionnement, les modules de refroidissement communiquent entre eux périodiquement, par l'intermédiaire d'un protocole collaboratif, afin d'échanger entre eux un ensemble de données, pour pouvoir vérifier d'abord si cet ensemble de données est cohérent, ce qui se traduira par un indicateur de cohérence devenant positif, et ensuite si cet ensemble de données reste cohérent de manière stable dans le temps, ce qui se traduire par un indicateur de stabilité devenant positif.

Lors de cet échange de données, chaque module de refroidissement contrôle plusieurs choses, à savoir qu'il contrôle une éventuelle perte de communication avec l'un ou l'autre des autres modules de refroidissement, qu'il contrôle également la cohérence des données échangées, ainsi que la stabilité dans le temps de la cohérence de ces données échangées. Ces contrôles peuvent être effectués alors que ce module de refroidissement est soit dans le statut autonome 16, soit dans le statut régulé 17, soit dans le statut redondant 20.

Le contrôle de perte de communication entre modules de refroidissement consiste pour chacun des modules de refroidissement de vérifier qu'il n'y a pas eu de problèmes de perte de communication sur le réseau Ethernet sur lequel ces modules de refroidissement communiquent entre eux. Plusieurs cas de figure peuvent être envisagés à ce sujet.

D'abord, l'un des modules de refroidissement peut être porté manquant, c'est-à-dire ne plus émettre sur le bus du réseau Ethernet, auquel cas ses données ne sont plus prises en compte dans l'ensemble des données du groupe et ne sont plus retenues pour effectuer l'opération de constatation de cohérence des données 33.

Ensuite, deux des trois modules de refroidissement peuvent être portés manquants, c'est-à-dire ne plus émettre sur le bus du réseau Ethernet, auquel cas seules les données du dernier module de refroidissement encore capable de communiquer donc d'émettre sur le bus Ethernet sont prises en compte dans l'ensemble des données du groupe et sont retenues pour effectuer l'opération de constatation de cohérence des données 33.

Enfin, l'un des modules de refroidissement peut être passé dans le statut défaillant 18 ou dans le statut exclu 19, auquel cas ses données ne sont plus prises en compte dans l'ensemble des données du groupe et ne sont plus retenues pour effectuer l'opération de constatation de cohérence des données 33.

Le contrôle de cohérence de l'ensemble des données échangées peut porter sur tout ou partie des données échangées. De manière périodique, par exemple chaque seconde, un processus va comparer si les paramètres de refroidissement sont égaux entre tous les modules de refroidissement, et si cette égalité est maintenue pendant au moins 10 secondes.

Les paramètres de refroidissement comprennent, d'une part le paramètre de module de refroidissement redondant dont la valeur est celle de l'identifiant du module de refroidissement qui est censé passer en redondance, c'est-à-dire au repos, lorsque les conditions seront favorables, c'est-à-dire lorsque l'opération de basculement vers la redondance 35 aura lieu, et d'autre part le paramètre de régulation du refroidissement dont la valeur est celle de la température cible de régulation du liquide caloporteur circulant dans le circuit hydraulique secondaire en sortie d'échangeur.

Au niveau d'une phase d'initialisation globale d'un ensemble d'armoires informatiques, le système de surveillance générale de la salle informatique ou bien un opérateur extérieur (un être humain chargé de la supervision ou de la maintenance de cette salle informatique), peut initialiser les paramètres de refroidissement de chaque armoire informatique en envoyant des commandes IPMI à tous les modules de refroidissement de l'armoire informatique correspondante. Normalement, ces commandes vont être envoyées et reçues par l'ensemble des modules de refroidissement pratiquement au même moment. Par mesure de sécurité supplémentaire, une marge de sécurité peut être prise et le créneau temporel pour effectuer ces envois peut être élargi à 10 secondes. Une fois que chaque module de refroidissement a reçu les commandes IPMI, il change ses paramètres de refroidissement et passe dans le statut régulé 17. Les autres modules de refroidissement ont à leur tour un créneau temporel de 10 secondes également pour recevoir ces valeurs de paramètres de refroidissement, mettre à jour leurs paramètres de refroidissement à partir de ces valeurs reçues, et renvoyer leurs propres paramètres de refroidissement aux autres modules de refroidissement. Si cet échange de données n'est pas réalisé dans le temps imparti, alors chaque module de refroidissement ayant constaté l'échec va passer dans le statut autonome 16, puisque l'indicateur de cohérence sera négatif.

L'indicateur de cohérence reste ou devient positif lorsque les trois conditions suivantes sont réalisées simultanément. La première condition est réalisée lorsque l'ensemble de données échangées entre modules de refroidissement a été mis à jour depuis au plus 2 secondes, c'est-à-dire qu'au plus une mise à jour envoyée a été manquée par l'un ou l'autre des modules de refroidissement. La deuxième condition est réalisée lorsque les paramètres de module de refroidissement redondant sont égaux entre eux pour tous les modules de refroidissement du groupe, et ceci depuis au moins 10 secondes. La troisième condition est réalisée lorsque les paramètres de régulation du refroidissement sont égaux entre eux pour tous les modules de refroidissement du groupe, et ceci depuis au moins 10 secondes.

A l'inverse, l'indicateur de cohérence reste ou devient négatif lorsqu'au moins l'une des trois conditions précédentes n'est pas ou n'est plus réalisée. Lorsque l'indicateur de cohérence est positif, le module de refroidissement peut passer du statut autonome 16 au statut régulé 17. Lorsque l'indicateur de cohérence est négatif, le module de refroidissement qui est dans le statut autonome 16 y reste. En cas de persistance d'un indicateur de cohérence négatif, une action correctrice est mise en place, par exemple par l'opérateur extérieur, pour analyser et corriger celui ou ceux des paramètres de refroidissement qui sont responsables de la persistance d'un indicateur de cohérence négatif.

Le contrôle de stabilité de l'ensemble des données échangées peut porter sur tout ou partie des données échangées. Le contrôle de stabilité porte sur les mêmes données que celles qui font l'objet du contrôle de cohérence. De manière périodique, par exemple chaque seconde, un processus va vérifier que l'indicateur de cohérence reste positif pendant un certain temps au cours duquel les modules de refroidissement restent synchronisés entre eux et aucun d'entre eux n'a reçu d'alarme de dysfonctionnement du refroidissement. Lorsque l'indicateur de stabilité reste ou devient positif, le module de refroidissement censé passer au repos, c'est-à-dire devenir redondant, va effectivement le devenir ou le rester s'il y est déjà.

L'indicateur de stabilité reste ou devient positif lorsque les trois conditions suivantes sont réalisées simultanément. La première condition est réalisée lorsque l'ensemble des indicateurs de cohérence au niveau des modules de refroidissement restent positifs pendant au moins 3 minutes. La deuxième condition est réalisée lorsqu'aucune alarme de dysfonctionnement du refroidissement n'a été reçue par un module de refroidissement. Une telle alarme de dysfonctionnement du refroidissement peut être par exemple reçue à cause d'une pompe ou d'un échangeur devenu défectueux. La troisième condition est réalisée lorsqu'au moins deux des trois (ou n des n+1) modules de refroidissement du groupe sont dans le statut régulé 17, le troisième (ou dernier) module de refroidissement du groupe étant quant à lui soit dans le statut régulé 17, soit dans le statut redondant 20.

A l'inverse, l'indicateur de stabilité reste ou devient négatif lorsqu'au moins l'une des trois conditions précédentes n'est pas ou n'est plus réalisée. Lorsque l'indicateur de stabilité est positif, et que l'un des modules de refroidissement pointe son paramètre de module de refroidissement sur son propre identifiant, alors ce module de refroidissement peut passer du statut régulé 17 au statut redondant 20, et seulement dans ce cas-là. Lorsque l'indicateur de stabilité est négatif, aucun module de refroidissement ne peut passer dans le statut redondant 20, mais doit au contraire rester dans le statut régulé 17.

La figure 6 représente l'agencement interne d'un exemple de module de refroidissement liquide compact selon un mode de réalisation de l'invention. Le module de refroidissement dissipe environ 60kW. Le module de refroidissement comprend un boîtier extérieur 100 intégrant plusieurs composants. Le fluide caloporteur est un liquide caloporteur, par exemple de l'eau glycolée. Un circuit hydraulique primaire 7, contenant un liquide caloporteur croise, sans mélange de liquide caloporteur, mais avec échange de chaleur entre les liquides caloporteurs, un circuit hydraulique secondaire 8, contenant un liquide caloporteur, à l'intérieur du boîtier extérieur 100 du module de refroidissement liquide, à l'intérieur d'un échangeur 102 de chaleur.

Le boîtier extérieur 100 comprend deux parois latérales longues 131 et 132 opposées l'une à l'autre, deux parois latérales courtes 133 et 134 opposées l'une à l'autre, un fond 135 opposé à un couvercle 136 qui n'est pas visible sur la figure 6, car il a été enlevé pour montrer l'intérieur du boîtier extérieur 100. Les termes de « longues » et de « courtes » signifient seulement que les parois latérales longues 131 et 132 sont plus longues que les parois latérales courtes 133 et 134. La forme générale du boîtier extérieur 100 est parallélépipédique. Les parois latérales longues 131 et 132 sont substantiellement de même longueur entre elles. Les parois latérales courtes 133 et 134 sont substantiellement de même longueur entre elles. Le boîtier extérieur 100 présente une longueur L de 76cm, une largeur 1 de 59.5cm et une épaisseur e de 15cm.

Parmi les composants intégrés dans le boîtier extérieur 100 se trouvent, une pompe 101, un échangeur de chaleur 102, une carte électronique 103, une vanne 104, une grille d'entrée 105, deux grilles de sortie 106 et 107, un clapet anti-retour 108, un espace longitudinal central dégagé 109, un détecteur de fuite 110, des capteurs de pression 111, un relais 112 d'alimentation électrique, des capteurs de température 113, un guide d'air 114, un ventilateur 117, des canalisations 121 à 123 dans le circuit hydraulique secondaire 8, des canalisations 124 et 125 dans le circuit hydraulique primaire 7. Les termes de tuyaux et de canalisations sont employés indifféremment.

La pompe 101 est orientée dans le sens de la longueur du boîtier extérieur 100 et située le long de la paroi latérale longue 132, elle est disposée tout contre cette paroi latérale longue 132. L'axe de la pompe 101 est aligné avec le tuyau amont 121 pour avoir une alimentation régulière de la pompe 101. Ce tuyau amont 121 est un tuyau souple pour raccorder la pompe 101, ce qui lui permet de compenser les défauts d'alignement et permet le démontage de la pompe 101 pour la maintenance.

L'échangeur de chaleur 102 est orienté dans le sens de la longueur du boîtier extérieur 100 et situé le long de l'autre paroi latérale longue 131, il est disposé tout près de cette autre paroi latérale longue 131 sans aucun autre élément entre eux qu'une canalisation. L'échangeur de chaleur 102 est un échangeur 102 couché sur le côté pour minimiser l'encombrement, un échangeur 102 à plaques et à flux croisés, en inox brasé cuivre, afin d'avoir une meilleure performance d'échange thermique.

Une couche d'isolation externe entoure d'une part l'échangeur 102 et d'autre part la ou les canalisations 124 et 125 d'une portion de circuit hydraulique primaire 7 située dans le module de refroidissement, de manière à éviter la condensation sur leurs parois externes, même lorsque la température de ces parois externes est inférieure à la température de rosée du module de refroidissement. Cette isolation, sur l'échangeur 102 et sur les tuyaux 124 et 125 du circuit primaire 7, évite ainsi un système de surveillance de la condensation susceptible de déclencher une alarme de dysfonctionnement du refroidissement sans raison valable. Les canalisations 124 et 125 présentent des coudes en sortie et en entrée de l'échangeur 102 pour minimiser l'encombrement.

La carte électronique 103 comprend elle-même deux parties qui sont d'une part une partie logique 115 et d'autre part une partie connexion 116. Cette carte électronique 103 de contrôle est disposée dans le prolongement longitudinal de cet espace longitudinal central dégagé 109 de manière à être directement léchée par l'écoulement d'air qui y passe. Les deux parties 115 et 116 séparables entre elles, de cette carte électronique 103, sont d'une part une partie logique 115 démontable sans démontage du reste du module de refroidissement et d'autre part une partie connexion 116 fixée sur le fond 135 du module de refroidissement sans en être séparément démontable. A cette partie connexion 116 sont reliées toutes les connexions des composants du module de refroidissement liquide aboutissant à cette carte électronique 103. Cette carte électronique 103 ne comprend pas de cache de protection et est directement en contact avec tout l'écoulement d'air provenant de l'espace longitudinal central dégagé 109. Cette carte électronique 103 dissipe une puissance calorique d'environ 10W. Cette carte électronique 103 est une carte de régulation électronique centralisée, refroidie par l'écoulement d'air créé par le ventilateur 117 de la pompe 101.

La vanne 104 est localisée sur une portion de circuit hydraulique primaire 7 située dans le module de refroidissement, ayant pour fonction de réguler indirectement la température de liquide caloporteur dans le circuit hydraulique secondaire 8 en sortie d'échangeur 102 de chaleur, cette vanne 104 étant avantageusement une vanne 104 à boisseau sphérique proportionnelle. Cette vanne 104 à boisseau sphérique proportionnelle, comprend un dispositif de réglage de la section de passage favorisant la linéarité de la réponse en débit en fonction de l'angle d'ouverture, avec un servomoteur monté couché pour minimiser l'encombrement, avec une commande électrique permettant une ouverture précise et une relecture de cette ouverture plus précise qu'avec une électrovanne proportionnelle.

La grille de ventilation d'entrée 105 est située dans la paroi latérale courte 133. Les deux grilles de ventilation de sortie 106 et 107 sont respectivement situées dans la paroi latérale courte 134. La grille 106 est une première grille 106 de ventilation de sortie d'air hors du module de refroidissement et est située juste en aval de la carte électronique 103. La grille 107 est une deuxième grille 107 de ventilation de sortie d'air hors du module de refroidissement et est située juste en aval de la vanne 104. La somme des surfaces des grilles 106 et 107 de ventilation de sortie d'air est égale à la surface de la grille 105 de ventilation d'entrée d'air.

Le clapet anti-retour 108 est situé sur le tronçon de circuit hydraulique secondaire 8 situé entre la sortie de la pompe 101 et l'entrée de l'échangeur 102 de chaleur. Le clapet anti-retour 108 est situé près de l'échangeur 102 pour créer un bloc démontable, ce qui est intéressant pour éviter le risque que l'écoulement en provenance des autres modules de refroidissement entre dans celui-ci lorsque sa pompe 101 est arrêtée.

L'espace longitudinal central dégagé 109 est disposé entre la pompe 101 et l'échangeur 102 de manière à y faciliter un écoulement d'air d'une grille 105 d'une paroi latérale courte 133 vers les deux grilles 106 et 107 de l'autre paroi latérale courte 134, cet écoulement d'air étant entraîné par le ventilateur 117 de la pompe 101.

Une portion de circuit hydraulique secondaire 8, pour la circulation d'un liquide caloporteur, située dans le module de refroidissement liquide, ne comprend aucune dérivation qui permettrait à la pompe 101 de fonctionner en circuit fermé et qui serait susceptible d'encombrer cet espace longitudinal central dégagé 109. Cet espace longitudinal central dégagé 109 entre les composants du module de refroidissement est suffisant pour favoriser le passage de l'air de refroidissement entre d'une part la grille amont 105 et d'autre part les grilles aval 106 et 107, de manière à ce qu'aussi bien la carte électronique 103 que la vanne 104 soient bien refroidies.

Le détecteur de fuite 110 est localisé dans le fond 135 du boîtier extérieur 100. Ce détecteur de fuite 110 est placé près du tuyau 125 d'évacuation, le fond 135 du boîtier extérieur 100 est étanche et permet d'accueillir une quantité notable de liquide en cas de fuite. La fuite n'est détectée que si elle est relativement importante, les petites fuites ne sont volontairement pas prises en compte, car très peu gênantes.

Les capteurs de pression 111 sont situés respectivement en entrée et en sortie de pompe 101 pour vérifier le fonctionnement de celle-ci.

Le relais 112 d'alimentation électrique de la pompe 101 est abrité dans un boîtier étanche qui accueille des tensions élevées d'alimentation de la pompe 101, en courant alternatif.

Les capteurs de température 113 assurent la surveillance et la régulation de la circulation de liquide caloporteur dans les circuits primaire 7 et secondaire 8 : il y en a un au niveau de chaque canalisation 121, 122, 124, 125 près de leur traversée de la paroi latérale courte 134.

Le guide d'air 114 canalise l'air entre d'une part la grille 105 de ventilation d'entrée d'air dans le module de refroidissement et d'autre part l'entrée de la pompe 101. La pompe 101 étant placée près de la grille 105 située en face avant du boîtier extérieur 100, son ventilateur 117 aspire de l'air frais venant de l'extérieur par cette grille 105 avec un guide d'air 114 pour éviter de ré-aspirer de l'air chaud qui était déjà passé dans le module de refroidissement.

Le ventilateur 117 de refroidissement par air de la pompe 101 est couplé à l'arbre électrique du moteur de la pompe 101.

La canalisation 121 située en amont de la pompe 101 dans le circuit hydraulique secondaire 8 et la canalisation 122 située entre la pompe 101 et l'échangeur 102 dans le circuit hydraulique secondaire 8, ainsi que la canalisation 123 située en aval de l'échangeur 102 dans le circuit hydraulique secondaire 8, forment la portion de circuit secondaire 8 située dans le module de refroidissement.

La canalisation 124 située en amont de l'échangeur 102 dans le circuit hydraulique primaire 7 et la canalisation 125 située en aval de l'échangeur 102 dans le circuit hydraulique primaire 7, forment la portion de circuit primaire 7 située dans le module de refroidissement.

Les coudes des différentes canalisations 121 à 125 sont des coudes à grand rayon de courbure pour minimiser la perte de charge et ne pas perturber l'écoulement de liquide caloporteur dans ces mêmes canalisations 121 à 125. Les traversées de la paroi latérale courte 134 du boîtier extérieur 100 sont compactes et ne présentent pas de changement de section important afin de minimiser la perte de charge.

Les circuits primaire 7 et secondaire 8 comprennent des raccords souples qui sont bien alignés avec les canalisations rigides 121 à 125 pour minimiser les changements de section de passage et les perturbations de l'écoulement de liquide caloporteur. De même, les fluctuations de pression sont réduites ainsi que les vibrations engendrées dans le module de refroidissement et dans tout le reste de l'armoire informatique. De plus, l'érosion est elle aussi minimisée par la régularité de l'écoulement de liquide caloporteur dans les canalisations rigides 121 à 125.

Bien entendu, la présente invention n'est pas limitée aux exemples et au mode de réalisation décrits et représentés, mais elle est susceptible de nombreuses variantes accessibles à l'homme de l'art.

## Revendications

1. Procédé de communication entre plusieurs modules de refroidissement liquide (4, 5, 6) d'un système de refroidissement d'un ou de plusieurs serveurs informatiques (3), **caractérisé en ce que** :
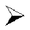 les modules de refroidissement (4, 5, 6) communiquent entre eux de manière à fonctionner en redondance N+l avec N supérieur ou égal à 2, de façon à pouvoir effectuer un échange standard de l'un quelconque de ces modules de refroidissement (4, 5, 6) sans arrêt du refroidissement et sans arrêt du fonctionnement du ou des serveurs (3),
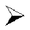 cette communication est assurée par un protocole collaboratif sans maître/esclave,
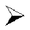 avant de passer (35) d'un mode actif (16, 17) où il refroidit à un mode de sauvegarde (20) où il ne refroidit plus, le module de refroidissement redondant (6) vérifie préalablement (33) d'une part qu'un ensemble de données est cohérent entre tous ces modules de refroidissement (4, 5, 6) et d'autre part que cette cohérence est maintenue pendant une durée prédéterminée.

2. Procédé de communication entre plusieurs modules de refroidissement liquide (4, 5, 6) selon la revendication 1, **caractérisé en ce que** :
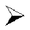 les modules de refroidissement (4, 5, 6) communiquent entre eux sur un réseau Ethernet (2),
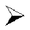 ce réseau Ethernet (2) pouvant aussi être le réseau sur lequel transitent des commandes externes à destination des serveurs informatiques (3) et qui est le réseau général de cluster informatique regroupant plusieurs armoires informatiques (1) pouvant participer à l'exécution d'une même tâche informatique.

3. Procédé de communication entre plusieurs modules de refroidissement liquide (4, 5, 6) selon l'une quelconque des revendications précédentes, **caractérisé en ce que** :
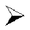 lors d'une phase d'initialisation, chaque module de refroidissement (4, 5, 6) diffuse (91) au moins son identifiant et un identifiant de l'armoire informatique (1) dans laquelle il est situé, 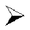 lors de cette phase d'initialisation, chaque module de refroidissement (4, 5, 6) ayant reçu l'identifiant d'un autre module de refroidissement (4, 5, 6) situé dans la même l'armoire informatique (1) que lui, lui renvoie (92) un message ciblé accusant réception et communiquant son propre identifiant et un identifiant de leur armoire informatique commune (1), de façon à former un groupe d'échange d'informations isolé des autres modules de refroidissement appartenant à d'autres groupes d'échange d'informations,
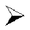 et après l'achèvement de cette phase d'initialisation, chaque module de refroidissement (4, 5, 6) envoie périodiquement (93), avec une période de rafraîchissement, ses données aux autres modules de refroidissement (4, 5, 6) du groupe d'échange d'informations qu'il a identifiés.

4. Procédé de communication entre plusieurs modules de refroidissement liquide (4, 5, 6) selon l'une quelconque des revendications précédentes, **caractérisé en ce que** :
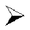 chacun des modules de refroidissement (4, 5, 6) peut avoir au moins les deux statuts suivants :
∘ dans le mode actif, un statut autonome (16), dans lequel le module de refroidissement (4, 5, 6) refroidit correctement, mais ne parvient pas à se synchroniser avec tous les autres modules de refroidissement (4, 5, 6),
∘ dans le mode actif, un statut régulé (17), dans lequel le module de refroidissement (4, 5, 6) refroidit correctement, et parvient à se synchroniser avec tous les autres modules de refroidissement (4, 5, 6).

5. Procédé de communication entre plusieurs modules de refroidissement liquide (4, 5, 6) selon l'une quelconque des revendications précédentes, **caractérisé en ce que** :
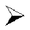 chacun des modules de refroidissement (4, 5, 6) peut avoir au moins les deux statuts suivants :
∘ en cas de panne, un statut défaillant (18), dans lequel le module de refroidissement (4, 5, 6) a arrêté (31) de refroidir correctement alors qu'il devrait continuer à refroidir correctement,
∘ dans le mode de sauvegarde, un statut redondant (20), dans lequel le module de refroidissement (4, 5, 6) est au repos mais reste prêt à remplacer immédiatement un autre module de refroidissement (4, 5, 6) qui deviendrait défaillant,
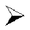 lorsqu'un module de refroidissement (4, 5, 6) passe (31) dans le statut défaillant (18), il arrête lui-même sa pompe (41, 51, 61, 101) de circulation de fluide caloporteur dans le circuit hydraulique secondaire (8).

6. Procédé de communication entre plusieurs modules de refroidissement liquide (4, 5, 6) selon l'une quelconque des revendications 4 à 5, **caractérisé en ce que** :
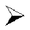 lorsqu'au départ, l'un des modules de refroidissement (4, 5, 6) réussit à passer (30) dans le statut autonome (16), l'armoire informatique (1) est démarrée et les serveurs informatiques (3) qu'elle contient également.

7. Procédé de communication entre plusieurs modules de refroidissement liquide (4, 5, 6) selon l'une quelconque des revendications 4 à 6, **caractérisé en ce que** :
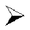 les modules de refroidissement (4, 5, 6) possèdent chacun un jeu de paramètres comprenant :
∘ un paramètre de module de refroidissement redondant pointant sur l'identifiant du module de refroidissement habilité à passer au statut redondant à la prochaine occasion favorable,
∘ au moins un paramètre de régulation du refroidissement pointant sur une valeur de consigne d'un paramètre régulant le refroidissement, qui est la température cible du fluide caloporteur dans le circuit hydraulique secondaire (8) en sortie de l'échangeur de chaleur (40, 50, 60, 102).

8. Procédé de communication entre plusieurs modules de refroidissement liquide (4, 5, 6) selon la revendication 7, **caractérisé en ce que** :
> chaque module de refroidissement (4, 5, 6) a un indicateur de cohérence :
∘ qui est positif lorsque sont remplies simultanément les trois conditions suivantes :
▪ledit module de refroidissement (4, 5, 6) a reçu de la part de tous les autres modules de refroidissement (4, 5, 6) les valeurs, d'au moins le paramètre de module de refroidissement redondant et le paramètre de régulation du refroidissement, mises à jour depuis moins d'une première durée prédéterminée,
▪toutes les valeurs du paramètre de module de refroidissement redondant reçues sont égales à sa propre valeur du paramètre de module de refroidissement redondant, pendant plus d'une deuxième durée prédéterminée,
▪toutes les valeurs du paramètre de régulation de refroidissement reçues sont égales à sa propre valeur du paramètre de régulation de refroidissement, pendant plus d'une troisième durée prédéterminée,
∘ qui est négatif si au moins l'une de ces trois conditions n'est pas remplie,
∘ ledit module de refroidissement (4, 5, 6) ne passant (33) du statut autonome (16) au statut régulé (17) que lorsque son indicateur de cohérence devient positif.

9. Procédé de communication entre plusieurs modules de refroidissement liquide (4, 5, 6) selon la revendication 8, **caractérisé en ce que** :
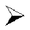 la première durée vaut au moins le double de la période de rafraîchissement des données par les modules de refroidissement (4, 5, 6), la première durée valant entre 1 et 10 secondes, ou entre 2 et 10 secondes,
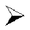 et les deuxième et troisième durées valent entre 5 et 60 secondes, ou entre 10 et 60 secondes, les deuxième et troisième durée étant avantageusement égales entre elles,
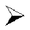 et lorsqu'un module de refroidissement (4, 5, 6) ne communique plus ses données aux autres modules de refroidissement (4, 5, 6), ses données stockées en mémoire ne sont plus prises en compte dans l'évaluation des indicateurs de cohérence des autres modules de refroidissement (4, 5, 6).

10. Procédé de communication entre plusieurs modules de refroidissement liquide (4, 5, 6) selon l'une quelconque des revendications 8 à 9, **caractérisé en ce que** :
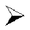 chaque module de refroidissement (4, 5, 6) a un indicateur de stabilité :
∘ qui est positif lorsque sont remplies simultanément les trois conditions suivantes :
▪les indicateurs de cohérence de tous les modules de refroidissement (4, 5, 6) sont positifs depuis au moins une quatrième durée, de préférence supérieure aux première, deuxième et troisième durées,
▪aucun module de refroidissement (4, 5, 6) n'a reçu d'alarme de dysfonctionnement du refroidissement,
■ au plus un seul des modules de refroidissement est dans le statut redondant (20), tous les modules ou tous les autres modules de refroidissement sont dans le statut régulé (17),
∘ qui est négatif si au moins l'une de ces trois conditions n'est pas remplie,
∘ ledit module de refroidissement (4, 5, 6) ne passant du statut régulé (17) au statut redondant (20) que lorsque sont remplies simultanément les deux conditions suivantes :
▪son paramètre de module de refroidissement redondant pointe sur son propre identifiant de module de refroidissement,
▪son indicateur de stabilité devient positif.

11. Procédé de communication entre plusieurs modules de refroidissement liquide (4, 5, 6) selon l'une quelconque des revendications 4 à 10, **caractérisé en ce que** :
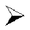 si tous les modules de refroidissement (4, 5, 6) restent dans le statut autonome (16) pendant au moins une cinquième durée prédéterminée, alors il y a une intervention d'un opérateur extérieur à l'armoire informatique (1), cette cinquième durée étant supérieure à 10 minutes.

12. Procédé de communication entre plusieurs modules de refroidissement liquide (4, 5, 6) selon l'une quelconque des revendications 8 à 11, **caractérisé en ce que** :
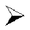 lorsqu'un module de refroidissement (4, 5, 6) est passé (31) dans le statut défaillant (18), ses données ne sont plus prises en compte dans l'évaluation des indicateurs de cohérence des autres modules de refroidissement (4, 5, 6).

13. Procédé de communication entre plusieurs modules de refroidissement liquide (4, 5, 6) selon la revendication 3 et l'une quelconque des revendications 4 à 12, **caractérisé en ce que** :
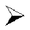 les données envoyées par chaque module de refroidissement (4, 5, 6), aux autres modules de refroidissement (4, 5, 6), comprennent :
∘ un identifiant de son groupe de modules de refroidissement (4, 5, 6) destinés à communiquer ensemble et situés dans une même armoire informatique (1), refroidissant ensemble un groupe de serveurs informatiques (3) situés dans cette armoire informatique (1),
∘ son propre identifiant de module de refroidissement (4, 5, 6),
∘ la valeur de son paramètre de module de refroidissement redondant,
∘ la valeur de son paramètre de régulation du refroidissement,
∘ un paramètre binaire correspondant à la présence ou à l'absence d'une alarme de dysfonctionnement du refroidissement.

14. Procédé de communication entre plusieurs modules de refroidissement liquide (4, 5, 6) selon la revendication 3 ou 13, **caractérisé en ce que** :
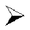 la période de rafraîchissement est comprise entre 0.5 et 2 secondes.

15. Procédé de communication entre plusieurs modules de refroidissement liquide (4, 5, 6) selon l'une quelconque des revendications 4 à 13, **caractérisé en ce que** :
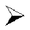 lorsque l'un des modules de refroidissement (4, 5, 6) passe (31) dans le statut défaillant (18), alors :
∘ son paramètre de module de refroidissement redondant pointe sur son propre identifiant de module de refroidissement,
∘ un ordre est envoyé aux autre modules de refroidissement (4, 5, 6) de pointer leur paramètre de module de refroidissement redondant sur l'identifiant de ce module de refroidissement devenu défaillant (18),
∘ le module de refroidissement qui est dans le statut redondant (20), passe dans le statut régulé (17) ou dans le statut autonome (16),
∘ l'alimentation électrique de tous les éléments fonctionnels de ce module de refroidissement devenu défaillant (18), à l'exception de sa carte électronique de contrôle (103), est désactivée.

16. Procédé de communication entre plusieurs modules de refroidissement liquide (4, 5, 6) selon la revendication 15, **caractérisé en ce que** :
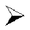 lorsque l'un des modules de refroidissement (4, 5, 6) est passé (31) dans le statut défaillant (18), il peut ensuite passer dans le statut exclu (19), et alors :
∘ une commande (36) spécifique de l'opérateur décide l'exclusion de ce module de refroidissement (4, 5, 6),
∘ une commande (29) spécifique de l'opérateur décidant l'inclusion de ce module de refroidissement (4, 5, 6) sera nécessaire pour remettre en marche le module de refroidissement exclu, un simple redémarrage de sa carte électronique de contrôle (103) ne permettant pas ladite remise en marche,
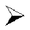 et lorsque l'un des modules de refroidissement (4, 5, 6) est passé dans le statut autonome (16) ou dans le statut régulé (17) ou dans le statut redondant (20), il peut ensuite passer directement dans le statut exclu (19) sans passer par le statut défaillant (18), et alors :
∘ une commande (36) spécifique de l'opérateur décide l'exclusion de ce module de refroidissement,
∘ une commande (29) spécifique de l'opérateur décidant l'inclusion de ce module de refroidissement (4, 5, 6) sera nécessaire pour remettre en marche le module de refroidissement exclu, un simple redémarrage de sa carte électronique de contrôle (103) ne permettant pas ladite remise en marche,
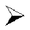 et lorsque l'un des modules de refroidissement (4, 5, 6) sort du statut exclu (19), alors :
∘ une commande (29) spécifique de l'opérateur décide l'inclusion de ce module de refroidissement (4, 5, 6),
∘ l'alimentation électrique de tous les éléments fonctionnels de ce module de refroidissement (4, 5, 6) devenu défaillant (18) est réactivée.

## Patentansprüche

1. Verfahren zur Kommunikation zwischen mehreren Flüssigkühlmodulen (4, 5, 6) eines Kühlsystems eines oder mehrerer Netzwerkserver (3), **dadurch gekennzeichnet, dass**:
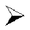 die Kühlmodule (4, 5, 6) so miteinander kommunizieren, dass sie in N+1-Redundanz mit N größer gleich 2 arbeiten, um einen Standardaustausch eines dieser Kühlmodule (4, 5, 6) durchführen zu können, ohne die Kühlung zu stoppen und ohne den Betrieb des/der Server(s) (3) zu stoppen,
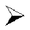 diese Kommunikation durch ein kollaboratives Protokoll ohne Master/Slave bereitgestellt wird,
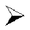 das redundante Kühlmodul (6) vor dem Umschalten (35) von einem aktiven Modus (16, 17), in dem es kühlt, in einen Backup-Modus (20), in dem es nicht mehr kühlt, einerseits überprüft (33), dass ein Satz von Daten zwischen all diesen Kühlmodulen (4, 5, 6) kohärent ist, und andererseits, dass diese Kohärenz über eine vorbestimmte Zeitdauer aufrechterhalten wird.

2. Verfahren zur Kommunikation zwischen mehreren Flüssigkühlmodulen (4, 5, 6) nach Anspruch 1, **dadurch gekennzeichnet, dass**:
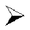 die Kühlmodule (4, 5, 6) über ein Ethernet-Netzwerk (2) miteinander kommunizieren,
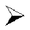 wobei dieses Ethernet-Netzwerk (2) auch das Netzwerk sein kann, über das externe Befehle an die Netzwerkserver (3) übertragen werden und das allgemeine Netzwerk eines Netzwerk-Clusters ist, das mehrere Netzwerkschränke (1) zusammenfasst, die an der Ausführung einer gemeinsamen Datenverarbeitungsaufgabe teilnehmen können.

3. Verfahren zur Kommunikation zwischen mehreren Flüssigkühlmodulen (4, 5, 6) nach einem der vorhergehenden Ansprüche, **dadurch gekennzeichnet, dass**:
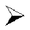 während einer Initialisierungsphase jedes Kühlmodul (4, 5, 6) wenigstens seine Kennung und eine Kennung des Netzwerkschranks (1), in dem es sich befindet, sendet (91),
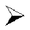 während dieser Initialisierungsphase jedes Kühlmodul (4, 5, 6), nachdem es die Kennung eines anderen Kühlmoduls (4, 5, 6), welches sich im gleichen Netzwerkschrank (1) befindet, empfangen hat, an dieses eine Zielnachricht zurück sendet (92), die den Empfang bestätigt und die eigene Kennung und eine Kennung ihres gemeinsamen Netzwerkschranks (1) mitteilt, um eine Informationsaustauschgruppe zu bilden, die von den anderen, zu anderen Informationsaustauschgruppen gehörenden Kühlmodulen isoliert ist,
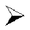 und dass nach Abschluss dieser Initialisierungsphase jedes Kühlmodul (4, 5, 6) seine Daten periodisch mit einer Aktualisierungszeitdauer an die anderen Kühlmodule (4, 5, 6) der von ihm identifizierten Informationsaustauschgruppe sendet (93).

4. Verfahren zur Kommunikation zwischen mehreren Flüssigkühlmodulen (4, 5, 6) nach einem der vorhergehenden Ansprüche, **dadurch gekennzeichnet, dass**:
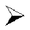 jedes der Kühlmodule (4, 5, 6) wenigstens die folgenden zwei Zustände aufweisen kann:
∘ im aktiven Modus einen autonomen Zustand (16), in dem das Kühlmodul (4, 5, 6) korrekt kühlt, es ihm aber nicht gelingt, sich mit allen anderen Kühlmodulen (4, 5, 6) zu synchronisieren,
∘ im aktiven Modus einen geregelten Zustand (17), in dem das Kühlmodul (4, 5, 6) korrekt kühlt und es ihm gelingt, sich mit allen anderen Kühlmodulen (4, 5, 6) zu synchronisieren.

5. Verfahren zur Kommunikation zwischen mehreren Flüssigkühlmodulen (4, 5, 6) nach einem der vorhergehenden Ansprüche, **dadurch gekennzeichnet, dass**:
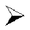 jedes der Kühlmodule (4, 5, 6) wenigstens die folgenden zwei Zustände aufweisen kann:
∘ im Falle eines Fehlers einen Fehlerzustand (18), in dem das Kühlmodul (4, 5, 6) nicht mehr korrekt kühlt (31), obwohl es weiterhin korrekt kühlen sollte,
∘ im Backup-Modus einen redundanten Zustand (20), in dem das Kühlmodul (4, 5, 6) inaktiv ist, aber bereit bleibt, ein anderes, defekt werdendes Kühlmodul (4, 5, 6) sofort zu ersetzen,
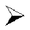 wenn ein Kühlmodul (4, 5, 6) in den Fehlerzustand (18) übergeht (31), stoppt es selbst seine Wärmeträgerflüssigkeits-Umwälzpumpe (41, 51, 61, 101) im sekundären Hydraulikkreis (8).

6. Verfahren zur Kommunikation zwischen mehreren Flüssigkühlmodulen (4, 5, 6) nach einem der Ansprüche 4 bis 5, **dadurch gekennzeichnet, dass**:
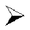 wenn es zunächst einem der Kühlmodule (4, 5, 6) gelingt, in den autonomen Zustand (16) überzugehen (30), der Netzwerkschrank (1) eingeschaltet wird und die darin enthaltenen Netzwerkserver (3) ebenfalls eingeschaltet werden.

7. Verfahren zur Kommunikation zwischen mehreren Flüssigkühlmodulen (4, 5, 6) nach einem der Ansprüche 4 bis 6, **dadurch gekennzeichnet, dass**:
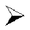 die Kühlmodule (4, 5, 6) jeweils einen Parametersatz aufweisen, umfassend:
∘ einen Parameter für ein redundantes Kühlmodul, der auf die Kennung des Kühlmoduls verweist, das bei der nächsten günstigen Gelegenheit in den redundanten Zustand umschalten kann,
∘ wenigstens einen Kühlungsregelungsparameter, der auf einen Sollwert eines Kühlungsregelungsparameters verweist, der die Zieltemperatur der Wärmeträgerflüssigkeit im sekundären Hydraulikkreislauf (8) am Ausgang des Wärmetauschers (40, 50, 60, 102) ist.

8. Verfahren zur Kommunikation zwischen mehreren Flüssigkühlmodulen (4, 5, 6) nach Anspruch 7, **dadurch gekennzeichnet, dass**:
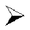 jedes Kühlmodul (4, 5, 6) einen Kohärenzindikator aufweist:
∘ der positiv ist, wenn die folgenden drei Bedingungen gleichzeitig erfüllt sind:
▪ das Kühlmodul (4, 5, 6) hat von allen anderen Kühlmodulen (4, 5, 6) wenigstens die Werte des Parameters des redundanten Kühlmoduls und des Parameters der Kühlungssteuerung erhalten, die seit weniger als einer ersten vorbestimmten Zeitdauer aktualisiert wurden,
▪ alle empfangenen Werte des Parameters des redundanten Kühlmoduls sind über mehr als eine zweite vorbestimmte Zeitdauer gleich dem eigenen Wert des Parameters des redundanten Kühlmoduls,
▪ alle empfangenen Werte des Parameters der Kühlungssteuerung sind über mehr als eine dritte vorbestimmte Zeitdauer gleich dem eigenen Wert des Parameters der Kühlungssteuerung,
∘ der negativ ist, wenn wenigstens eine dieser drei Bedingungen nicht erfüllt ist,
∘ wobei das Kühlmodul (4, 5, 6) nur dann vom autonomen Zustand (16) in den geregelten Zustand (17) wechselt (33), wenn sein Kohärenzindikator positiv wird.

9. Verfahren zur Kommunikation zwischen mehreren Flüssigkühlmodulen (4, 5, 6) nach Anspruch 8, **dadurch gekennzeichnet, dass**
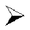 die erste Zeitdauer wenigstens dem Doppelten der Zeitdauer der Datenaktualisierung durch die Kühlmodule (4, 5, 6) entspricht, wobei die erste Zeitdauer zwischen 1 und 10 Sekunden oder zwischen 2 und 10 Sekunden liegt,
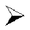 die zweite und dritte Dauer zwischen 5 und 60 Sekunden oder zwischen 10 und 60 Sekunden liegen, wobei die zweite und dritte Dauer vorteilhafterweise gleich sind,
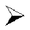 und dass, wenn ein Kühlmodul (4, 5, 6) seine Daten nicht mehr an die anderen Kühlmodule (4, 5, 6) übermittelt, seine im Speicher abgelegten Daten bei der Neubewertung der Kohärenzindikatoren der anderen Kühlmodule (4, 5, 6) nicht mehr berücksichtigt werden.

10. Verfahren zur Kommunikation zwischen mehreren Flüssigkühlmodulen (4, 5, 6) nach einem der Ansprüche 8 bis 9, **dadurch gekennzeichnet, dass**: 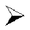 jedes Kühlmodul (4, 5, 6) einen Stabilitätsindikator aufweist:
∘ der positiv ist, wenn die folgenden drei Bedingungen gleichzeitig erfüllt sind:
▪ ▪ die Kohärenzindikatoren aller Kühlmodule (4, 5, 6) sind seit wenigstens eine vierte Zeitdauer positiv, die vorzugsweise länger als die erste, zweite und dritte Zeitdauer ist,
▪ kein Kühlmodul (4, 5, 6) hat einen Kühlstörungsalarm erhalten,
▪ höchstens eines der Kühlmodule ist im redundanten Zustand (20), alle oder alle anderen Kühlmodule sind im geregelten Zustand (17),
∘ der negativ ist, wenn wenigstens eine dieser drei Bedingungen nicht erfüllt ist,
∘ wobei das Kühlmodul (4, 5, 6) nur dann vom geregelten Zustand (17) in den redundanten Zustand (20) wechselt, wenn beide der folgenden Bedingungen gleichzeitig erfüllt sind:
▪ der Parameter des redundanten Kühlmoduls verweist auf seine eigene Kühlmodul-Kennung,
▪ sein Stabilitätsindikator wird positiv.

11. Verfahren zur Kommunikation zwischen mehreren Flüssigkühlmodulen (4, 5, 6) nach einem der Ansprüche 4 bis 10, **dadurch gekennzeichnet, dass**:
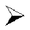 wenn alle Kühlmodule (4, 5, 6) über wenigstens eine fünfte vorbestimmte Zeitdauer im autonomen Zustand (16) verbleiben, ein Eingriff durch einen Operator außerhalb des Netzwerkschranks (1) erfolgt, wobei diese fünfte Zeitdauer größer als 10 Minuten ist.

12. Verfahren zur Kommunikation zwischen mehreren Flüssigkühlmodulen (4, 5, 6) nach einem der Ansprüche 8 bis 11, **dadurch gekennzeichnet, dass**:
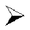 wenn ein Kühlmodul (4, 5, 6) in den Fehlerzustand (18) geschaltet wird (31), dessen Daten bei der Neubewertung der Kohärenzindikatoren der anderen Kühlmodule (4, 5, 6) nicht mehr berücksichtigt werden.

13. Verfahren zur Kommunikation zwischen mehreren Flüssigkühlmodulen (4, 5, 6) nach Anspruch 3 und einem der Ansprüche 4 bis 12, **dadurch gekennzeichnet, dass**:
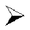 die Daten, die von jedem Kühlmodul (4, 5, 6) an die anderen Kühlmodule (4, 5, 6) gesendet werden, umfassen:
∘ eine Kennung seiner Gruppe von Kühlmodulen (4, 5, 6), die dazu bestimmt sind, miteinander zu kommunizieren und sich in einem gleichen Netzwerkschrank (1) befinden, und die gemeinsam eine Gruppe von Netzwerkservern (3) kühlen, die sich in diesem Netzwerkschrank (1) befinden,
∘ eine eigene Kühlmodul-Kennung (4, 5, 6),
∘ den Wert des eigenen Parameters des redundanten Kühlmoduls,
∘ den Wert des eigenen Parameters der Kühlungssteuerung,
∘ einen binären Parameter, der dem Vorhandensein oder Nichtvorhandensein eines Kühlungsstörungsalarms entspricht.

14. Verfahren zur Kommunikation zwischen mehreren Flüssigkühlmodulen (4, 5, 6) nach Anspruch 3 oder 13, **dadurch gekennzeichnet, dass**:
> die Aktualisierungszeitdauer zwischen 0,5 und 2 Sekunden liegt.

15. Verfahren zur Kommunikation zwischen mehreren Flüssigkühlmodulen (4, 5, 6) nach einem der Ansprüche 4 bis 13, **dadurch gekennzeichnet, dass**:
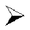 wenn eines der Kühlmodule (4, 5, 6) in den Fehlerzustand (18) wechselt (31),
∘ sein Parameter des redundanten Kühlmoduls auf seine eigene Kühlmodul-Kennung verweist,
∘ ein Befehl an die anderen Kühlmodule (4, 5, 6) gesendet wird, ihren Parameter des redundanten Kühlmoduls auf die Kennung dieses fehlerhaften Kühlmoduls (18) zu verweisen,
∘ das Kühlmodul, das sich im redundanten Zustand (20) befindet, in den geregelten Zustand (17) oder in den autonomen Zustand (16) wechselt,
∘ die Stromversorgung aller Funktionselemente dieses fehlerhaft gewordenen Kühlmoduls (18), mit Ausnahme seiner elektronischen Steuerplatine (103), abgeschaltet wird.

16. Verfahren zur Kommunikation zwischen mehreren Flüssigkühlmodulen (4, 5, 6) nach Anspruch 15, **dadurch gekennzeichnet, dass**:
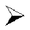 wenn eines der Kühlmodule (4, 5, 6) in den Fehlerzustand (18) gewechselt ist (31), es dann in den Ausschlusszustand (19) wechseln kann, und dann:
∘ ein bestimmter Operator-Befehl (36) den Ausschluss dieses Kühlmoduls (4, 5, 6) beschließt,
∘ ein bestimmter Operator-Befehl (29) der den Einschluss dieses Kühlmoduls (4, 5, 6) beschließt, erforderlich ist, um das ausgeschlossene Kühlmodul neu zu starten, wobei ein einfacher Neustart seiner elektronischen Steuerplatine (103) diesen Neustart nicht ermöglicht,
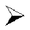 und wenn eines der Kühlmodule (4, 5, 6) in den autonomen Zustand (16) oder den geregelten Zustand (17) oder den redundanten Zustand (20) gewechselt ist, es dann direkt in den Ausschlusszustand (19) wechseln kann, ohne den Fehlerzustand (18) zu durchlaufen, und dann:
∘ ein bestimmter Befehl (36) des Operators den Ausschluss dieses Kühlmoduls beschließt,
∘ ein spezifischer Befehl (29) des Operators, der den Ausschluss dieses Kühlmoduls (4, 5, 6) beschließt, notwendig ist, um das ausgeschlossene Kühlmodul neu zu starten, wobei ein einfacher Neustart seiner elektronischen Steuerplatine (103) diesen Neustart nicht ermöglicht,
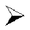 und wenn eines der Kühlmodule (4, 5, 6) den Ausschlusszustand (19) verlässt, dann
∘ ein bestimmter Befehl (29) des Operators den Einschluss dieses Kühlmoduls (4, 5, 6) beschließt,
∘ die Spannungsversorgung aller Funktionselemente dieses fehlerhaft gewordenen (18) Kühlmoduls (4, 5, 6) reaktiviert wird.

## Claims

1. A method for communication between several liquid cooling modules (4, 5, 6) of a system for cooling one or several computer server(s) (3), **characterized in that**:
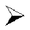 the cooling modules (4, 5, 6) communicate with each other so as to operate under N+1 redundancy with N greater than or equal to 2, so as to be able to perform a standard replacement of any one of these cooling modules (4, 5, 6) without stopping cooling and without stopping operation of the server(s) (3),
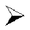 this communication is ensured by a collaborative protocol with no master/slave,
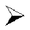 before switching (35) from an active mode (16, 17) where it cools into a backup mode (20) where it no longer cools, the redundant cooling module (6) checks up beforehand (33), on the one hand, whether a set of data is coherent between all these cooling modules (4, 5, 6) and, on the other hand, whether this coherence is maintained over a predetermined duration.

2. The method for communication between several liquid cooling modules (4, 5, 6) according to claim 1, **characterized in that**:
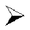 the cooling modules (4, 5, 6) communicate with each other on an Ethernet network (2),
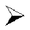 this Ethernet network (2) may also be the network on which external commands transit to the computer servers (3) and which is the computer cluster general network grouping together several computer racks (1) able to participate in the execution of the same computer task.

3. The method for communication between several liquid cooling modules (4, 5, 6) according to any one of the preceding claims, **characterized in that**:
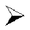 during an initialization phase, each cooling module (4, 5, 6) broadcasts (91) at least its identifier and an identifier of the computer rack (1) in which it is located,
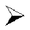 during this initialization phase, each cooling module (4, 5, 6) having received the identifier of another cooling module (4, 5, 6) located in the same computer rack (1) as itself, sends back (92) a targeted message thereto acknowledging receipt and communicating its own identifier and an identifier of their common computer rack (1), so as to form an information exchange group isolated from the other cooling modules belonging to other information exchange groups,
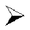 and after completion of this initialization phase, each cooling module (4, 5, 6) periodically sends (93), with a refresh period, its data to the other cooling modules (4, 5, 6) of the information exchange group identified thereby.

4. The method for communication between several liquid cooling modules (4, 5, 6) according to any one of the preceding claims, **characterized in that**:
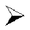 each of the cooling modules (4, 5, 6) may have at least the following two statuses:
∘ in the active mode, a standalone status (16), in which the cooling module (4, 5, 6) cools properly, but fails to synchronize with all the other cooling modules (4, 5, 6),
∘ in the active mode, a regulated status (17), in which the cooling module (4, 5, 6) cools properly, and manages to synchronize with all the other cooling modules (4, 5,6).

5. The method for communication between several liquid cooling modules (4, 5, 6) according to any one of the preceding claims, **characterized in that**:
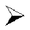 each of the cooling modules (4, 5, 6) may have at least the following two statuses:
∘ in the event of a failure, a faulty status (18), in which the cooling module (4, 5, 6) has stopped (31) cooling properly while it should keep cooling properly,
∘ in the backup mode, a redundant status (20), in which the cooling module (4, 5, 6) is at rest but remains ready to immediately replace another cooling module (4, 5, 6) that would have become faulty,
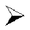 when a cooling module (4, 5, 6) switches (31) into the faulty status (18), it stops, by itself, its pump (41, 51, 61, 101) for heat-transfer fluid circulation in the secondary hydraulic circuit (8).

6. The method for communication between several liquid cooling modules (4, 5, 6) according to any one of claims 4 to 5, **characterized in that**:
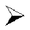 when initially, one of the cooling modules (4, 5, 6) succeeds in switching (30) into the standalone status (16), the computer rack (1) is started and the computer servers (3) it contains too.

7. The method for communication between several liquid cooling modules (4, 5, 6) according to any one of claims 4 to 6, **characterized in that**:
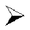 each of the cooling modules (4, 5, 6) has a set of parameters comprising:
∘ a redundant cooling module parameter pointing on the identifier of the cooling module authorized to switch into the redundant status at the next favorable opportunity,
∘ at least one cooling regulation parameter pointing on a setpoint value of a parameter regulating cooling, which is the target temperature of the heat-transfer fluid in the secondary hydraulic circuit (8) at the outlet of the heat exchanger (40, 50, 60, 102).

8. The method for communication between several liquid cooling modules (4, 5, 6) according to claim 7, **characterized in that**:
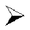 each cooling module (4, 5, 6) has a coherence indicator:
∘ which is positive when the following three conditions are simultaneously met:
▪ said cooling module (4, 5, 6) has received from all the other cooling modules (4, 5, 6) the values of at least the redundant cooling module parameter and the cooling regulation parameter, updated since less than a first predetermined duration,
▪ all received values of the redundant cooling module parameter are equal to its own value of the redundant cooling module parameter, over more than a second predetermined duration,
▪ all received values of the cooling regulation parameter are equal to its own value of the cooling regulation parameter, over more than a third predetermined duration,
∘ which is negative if at least one of these three conditions is not met,
∘ said cooling module (4, 5, 6) switching (33) from the standalone status (16) into the regulated status (17) only when its coherence indicator becomes positive.

9. The method for communication between several liquid cooling modules (4, 5, 6) according to claim 8, **characterized in that**:
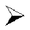 the first duration is at least twice as long as the period of data refresh by the cooling modules (4, 5, 6), the first duration ranging between 1 and 10 seconds, or between 2 and 10 seconds,
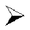 and the second and third durations range between 5 and 60 seconds, or
between 10 and 60 seconds, the second and third durations being advantageously equal to one another,
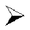 and when a cooling module (4, 5, 6) no longer communicates its data to the other cooling modules (4, 5, 6), its data stored in memory are no longer taken into account in the assessment of the coherence indicators of the other cooling modules (4, 5,6).

10. The method for communication between several liquid cooling modules (4, 5, 6) according to any one of claims 8 to 9, **characterized in that**:
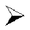 each cooling module (4, 5, 6) has a stability indicator:
∘ which is positive when the following three conditions are simultaneously met:
▪ the coherence indicators of all cooling modules (4, 5, 6) are positive since at least a fourth duration, preferably longer than the first, second and third durations,
▪ no cooling module (4, 5, 6) has received a cooling malfunction alarm,
▪ at most, only one of the cooling modules is in the redundant status (20), all modules or all other cooling modules are in the regulated status (17),
∘ which is negative if at least one of these three conditions is not met,
∘ said cooling module (4, 5, 6) switching from the regulated status (17) into the redundant status (20) only when the following two conditions are simultaneously met:
▪ its redundant cooling module parameter points on its own cooling module identifier,
▪ its stability indicator becomes positive.

11. The method for communication between several liquid cooling modules (4, 5, 6) according to any one of claims 4 to 10, **characterized in that**:
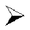 if all cooling modules (4, 5, 6) remain in the standalone status (16) over at least a fifth predetermined duration, then there is an intervention of an operator external to the computer rack (1), this fifth duration being longer than 10 minutes.

12. The method for communication between several liquid cooling modules (4, 5, 6) according to any one of claims 8 to 11, **characterized in that**:
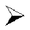 when a cooling module (4, 5, 6) has switched (31) into the faulty status (18), its data are no longer taken into account in the assessment of the coherence indicators of the other cooling modules (4, 5, 6).

13. The method for communication between several liquid cooling modules (4, 5, 6) according to claim 3 and any one of claims 4 to 12, **characterized in that**:
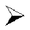 the data sent by each cooling module (4, 5, 6), to the other cooling modules (4, 5, 6), comprise:
∘ an identifier of its group of cooling modules (4, 5, 6) intended to communicate together and located in the same computer rack (1), cooling together a group of computer servers (3) located in this computer rack (1),
∘ its own cooling module identifier (4, 5, 6),
∘ the value of its redundant cooling module parameter,
∘ the value of its cooling regulation parameter,
∘ a binary parameter corresponding to the presence or to the absence of a cooling malfunction alarm.

14. The method for communication between several liquid cooling modules (4, 5, 6) according to claim 3 or 13, **characterized in that**:
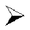 the refresh period is comprised between 0.5 and 2 seconds.

15. The method for communication between several liquid cooling modules (4, 5, 6) according to any one of claims 4 to 13, **characterized in that**:
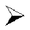 when one of the cooling modules (4, 5, 6) switches (31) into the faulty status (18), then:
∘ its redundant cooling module parameter points on its own cooling module identifier,
∘ an order is sent to the other cooling modules (4, 5, 6) to point their redundant cooling module parameter on the identifier of this cooling module having become faulty (18),
∘ the cooling module that is in the redundant status (20), switches into the regulated status (17) or into the standalone status (16),
∘ the electric power supply of all of the functional elements of this cooling module having become faulty (18), with the exception of its electronic control board (103), is deactivated.

16. The method for communication between several liquid cooling modules (4, 5, 6) according to claim 15, **characterized in that**:
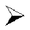 when one of the cooling modules (4, 5, 6) has switched (31) into the faulty status (18), it can switch afterwards into the excluded status (19), and then:
∘ a specific command (36) of the operator decides the exclusion of this cooling module (4, 5, 6),
∘ a specific command (29) of the operator deciding the inclusion of this cooling module (4, 5, 6) will be necessary to reset the excluded cooling module, a simple restart of its electronic control board (103) cannot enable said reset,
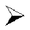 and when one of the cooling modules (4, 5, 6) has switched into the standalone status (16) or into the regulated status (17) or into the redundant status (20), it can switch afterwards directly into the excluded status (19) without passing through the faulty status (18), and then:
∘ a specific command (36) of the operator decides the exclusion of this cooling module,
∘ a specific command (29) of the operator deciding the inclusion of this cooling module (4, 5, 6) will be necessary to reset the excluded cooling module, a simple restart of its electronic control board (103) cannot enable said reset,
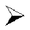 and when one of the cooling modules (4, 5, 6) quits the excluded status (19), then:
∘ a specific command (29) of the operator decides the inclusion of this cooling module (4, 5, 6),
∘ the electric power supply of all of the functional elements of this cooling modules (4, 5, 6) having become faulty (18) is reactivated.
